# EUROPEAN PATENT APPLICATION

(11) **EP 4 542 638 A1**
(43) Date of publication of application: **23.04.2025**
(21) Application number: 23823574.1
(22) Date of filing: 11.05.2023
(51) Int. Cl.: H01L 23/15, H01L 23/02, H01L 23/12

(54) **SEMICONDUCTOR DEVICE**

(30) Priority: 16.06.2022 JP 2022097461
(71) Applicant: Sony Semiconductor Solutions Corporation, Atsugi-shi, Kanagawa 243-0014 (JP)
(72) Inventor: ADACHI, Kiwamu, Atsugi-shi, Kanagawa 243-0014 (JP); MITARAI, Shun, Atsugi-shi, Kanagawa 243-0014 (JP); IGARASHI, Takahiro, Atsugi-shi, Kanagawa 243-0014 (JP); SEKI, Kousuke, Atsugi-shi, Kanagawa 243-0014 (JP); OKA, Shuichi, Atsugi-shi, Kanagawa 243-0014 (JP)
(74) Representative: MFG Patentanwälte Meyer-Wildhagen Meggle-Freund Gerhard PartG mbB
(86) International application number: PCT/JP2023/017783
(87) International publication number: WO 2023/243271

(57) **Abstract**

Provided is a semiconductor device capable of protecting a glass substrate and having high reliability even when a glass stacked substrate is used.

A semiconductor device according to an embodiment includes: a glass substrate including a first surface, a second surface opposite to the first surface, and a first side surface between the first surface and the second surface; a first frame-shaped material having a third surface on the first surface side, a fourth surface on the second surface side, and a first inner side surface facing the first side surface, the first frame-shaped material being provided around the glass substrate; a first insulating film provided between the first side surface and the first inner side surface and on the first surface and the third surface; a first wiring layer provided on the first insulating film of the first and third surfaces; and a second insulating film provided on the first wiring layer.

## Description

### TECHNICAL FIELD

The present disclosure relates to a semiconductor device.

### BACKGROUND ART

A glass substrate can be applied with a semiconductor processing technique, has a low coefficient of thermal expansion (CTE), and is excellent in flatness, and thus is promising as a substrate for a semiconductor device such as an optical component or a high-frequency component.

### CITATION LIST

### PATENT DOCUMENT

PATENT DOCUMENT 1: Japanese Patent Application Laid-Open No. 2021-108317
PATENT DOCUMENT 2: Japanese Patent Application Laid-Open No. 2015-135940
PATENT DOCUMENT 3: Japanese Patent Application Laid-Open No. 2015-118954

### SUMMARY OF THE INVENTION

### PROBLEMS TO BE SOLVED BY THE INVENTION

The mechanical strength of a glass substrate may decrease due to damage generated when the glass substrate is singulated by dicing. Therefore, in order to improve the mechanical strength of the glass substrate, it is considered to provide a frame member around the glass substrate.

However, disconnection or deformation may occur due to a difference between the thickness of the glass substrate and the thickness of the frame member. Furthermore, there is a case where a difference in the coefficient of thermal expansion between the glass substrate and a mounting substrate may damage the connection between the glass substrate and the mounting substrate.

Moreover, in a case where a glass stacked substrate obtained by stacking a plurality of glass thin plates is used as the glass substrate, it is difficult to control the thickness with high accuracy. The thickness of the wiring in the glass stacked substrate becomes thin, and impedance matching with respect to a high frequency may become difficult.

Therefore, the present disclosure provides a semiconductor device capable of protecting a glass substrate and having high reliability even when a glass stacked substrate is used.

### SOLUTIONS TO PROBLEMS

A semiconductor device according to one aspect of the present disclosure includes: a glass substrate including a first surface, a second surface opposite to the first surface, and a first side surface between the first surface and the second surface; a first frame-shaped material having a third surface on the first surface side, a fourth surface on the second surface side, and a first inner side surface facing the first side surface, the first frame-shaped material being provided around the glass substrate; a first insulating film provided between the first side surface and the first inner side surface and on the first surface and the third surface; a first wiring layer provided on the first insulating film of the first and third surfaces; and a second insulating film provided on the first wiring layer.

The first insulating film is also provided on the second surface and the fourth surface, and the semiconductor device further includes a second wiring layer provided on the first insulating film of the second and fourth surfaces, and a third insulating film provided on the second wiring layer.

The semiconductor device further includes a first pad provided on the third surface and electrically connected to the first wiring layer exposed from the second insulating film.

The semiconductor device further includes a second pad provided on the fourth surface and electrically connected to the second wiring layer exposed from the third insulating film.

The glass substrate further includes a plurality of stacked glass thin plates, a third wiring layer provided between the glass thin plates, and a fourth insulating film provided between the glass thin plates.

The first surface of the glass substrate and the third surface of the first frame-shaped material are shifted in a thickness direction of the glass substrate, and a surface of the first insulating film is substantially flush above the first surface and the third surface.

The second surface of the glass substrate and the fourth surface of the first frame-shaped material are shifted in a thickness direction of the glass substrate, and a surface of the first insulating film is substantially flush above the second surface and the fourth surface.

The first insulating film on the second and fourth surfaces is lower in Young's modulus than the first insulating film on the first and third surfaces.

The semiconductor device further includes an electronic component provided on the third surface or the fourth surface of the first frame-shaped material and electrically connected to the first wiring or the second wiring.

The semiconductor device further includes a first capacitive element provided between the third surface of the first frame-shaped material and the first insulating film and configured by stacking a first conductive film, a fifth insulating film, and a second conductive film.

The semiconductor device further includes a second capacitive element provided between the fourth surface of the first frame-shaped material and the first insulating film and configured by stacking a first conductive film, a fifth insulating film, and a second conductive film.

The semiconductor device further includes a first through electrode provided between the third surface and the fourth surface of the first frame-shaped material and electrically connected between the first wiring and the second wiring.

The semiconductor device further includes a semiconductor chip provided on the glass substrate, a frame provided on the third surface of the first frame-shaped material, a lens provided on the frame and disposed above the semiconductor chip, and a fastening member that is fitted into a fastening hole provided in the first frame-shaped material and a fastening hole provided in the frame to fix the frame to the first frame-shaped material.

The semiconductor device further includes a semiconductor chip provided on the glass substrate, a frame provided on the third surface of the first frame-shaped material, and a protective member provided on the frame and disposed above the semiconductor chip.

The semiconductor device further includes a semiconductor chip provided on the glass substrate, a second frame-shaped material including a second through electrode electrically connected to the first wiring, the second frame-shaped material being provided on the first frame-shaped material, and a metal wire connecting the semiconductor chip and the second through electrode.

The semiconductor device further includes a semiconductor chip provided on the glass substrate, and a frame provided on the third surface of the first frame-shaped material and having a third conductive film electrically connecting the semiconductor chip and the first wiring.

A semiconductor device includes a glass substrate including a first surface, a second surface opposite to the first surface, and a first side surface between the first surface and the second surface, a first frame-shaped material having a third surface on the first surface side, a fourth surface on the second surface side, and a first inner side surface facing the first side surface, the first frame-shaped material being provided around the glass substrate and having higher heat dissipation than the glass substrate, and a first insulating film provided between the first side surface and the first inner side surface and on the first surface and the third surface.

A manufacturing method of a semiconductor device according to one aspect of the present disclosure includes arranging a glass substrate including a first surface, a second surface opposite to the first surface, and a first side surface between the first surface and the second surface, and a first frame-shaped material including a third surface on the first surface side, a fourth surface on the second surface side, and a first inner side surface in the first frame-shaped material such that the first inner side surface and the first side surface face each other, forming a first insulating film between the first side surface and the first inner side surface and on the first surface and the third surface, forming a first wiring layer on the first insulating film of the first and third surfaces, and forming a second insulating film on the first wiring layer.

A manufacturing method of a semiconductor device according to one aspect of the present disclosure includes arranging a glass substrate including a first surface, a second surface opposite to the first surface, and a first side surface between the first surface and the second surface, and a first frame-shaped material including a third surface on the first surface side, a fourth surface on the second surface side, and a first inner side surface, and having higher heat dissipation than the glass substrate in the first frame-shaped material such that the first inner side surface and the first side surface face each other, and forming a first insulating film between the first side surface and the first inner side surface and on the first surface and the third surface.

### BRIEF DESCRIPTION OF DRAWINGS

Fig. 1 is a plan view illustrating a configuration example of a semiconductor device according to a first embodiment.
Fig. 2 is a cross-sectional view illustrating a configuration example of the semiconductor device according to the first embodiment.
Fig. 3 is a cross-sectional view illustrating a configuration around an end portion of a glass substrate 10.
Fig. 4 is a cross-sectional view illustrating a configuration example of a semiconductor device according to a second embodiment.
Fig. 5 is a cross-sectional view illustrating a configuration example of a semiconductor device according to a third embodiment.
Fig. 6 is a cross-sectional view illustrating a configuration example of a semiconductor device according to a fourth embodiment.
Fig. 7 is a cross-sectional view illustrating a configuration example of a semiconductor device according to a fifth embodiment.
Fig. 8 is a cross-sectional view illustrating a modification of the fourth or fifth embodiment.
Fig. 9 is a cross-sectional view illustrating a configuration example of a semiconductor device according to a sixth embodiment.
Fig. 10 is a cross-sectional view illustrating a configuration example of the semiconductor device according to the sixth embodiment.
Fig. 11 is a cross-sectional view illustrating an example of a staggered structure, a stacked via structure, and a through hole structure.
Fig. 12 is a schematic plan view illustrating a configuration example of a semiconductor device according to a seventh embodiment.
Fig. 13 is a cross-sectional view illustrating a configuration example of the semiconductor device according to the seventh embodiment.
Fig. 14 is a cross-sectional view illustrating a configuration example of a semiconductor device according to an eighth embodiment.
Fig. 15 is a cross-sectional view illustrating a configuration example of a semiconductor device according to a ninth embodiment.
Fig. 16 is a cross-sectional view illustrating a configuration example of a semiconductor device according to a tenth embodiment.
Fig. 17 is a cross-sectional view illustrating a configuration example of a semiconductor device according to an eleventh embodiment.
Fig. 18 is a cross-sectional view illustrating an example of a glass substrate.
Fig. 19 is a cross-sectional view illustrating an example of a glass substrate.
Fig. 20 is a cross-sectional view illustrating an example of a frame-shaped material.
Fig. 21 is a cross-sectional view illustrating an example of a frame-shaped material.
Fig. 22 is a cross-sectional view illustrating an example of a frame-shaped material.
Fig. 23 is a plan view illustrating a configuration of a frame-shaped material 20 before dicing.
Fig. 24A is a cross-sectional view illustrating an example of a manufacturing method of the semiconductor device according to the first embodiment.
Fig. 24B is a cross-sectional view illustrating an example of a manufacturing method of the semiconductor device according to the first embodiment.
Fig. 24C is a cross-sectional view illustrating an example of a manufacturing method of the semiconductor device according to the first embodiment.
Fig. 24D is a cross-sectional view illustrating an example of a manufacturing method of the semiconductor device according to the first embodiment.
Fig. 24E is a cross-sectional view illustrating an example of a manufacturing method of the semiconductor device according to the first embodiment.
Fig. 24F is a cross-sectional view illustrating an example of a manufacturing method of the semiconductor device according to the first embodiment.
Fig. 24G is a cross-sectional view illustrating an example of a manufacturing method of the semiconductor device according to the first embodiment.
Fig. 25 is a plan view illustrating an example of a manufacturing method of the semiconductor device.
Fig. 26 is a plan view illustrating an example of a manufacturing method of the semiconductor device according to the seventh embodiment.
Fig. 27 is a cross-sectional view illustrating an example of a manufacturing method of the semiconductor device according to the eighth embodiment.
Fig. 28 is a cross-sectional view illustrating an example of a manufacturing method of the semiconductor device according to the eighth embodiment.
Fig. 29A is a cross-sectional view illustrating an example of a manufacturing method of the semiconductor device according to the ninth embodiment.
Fig. 29B is a cross-sectional view illustrating an example of a manufacturing method of the semiconductor device according to the ninth embodiment.
Fig. 29C is a cross-sectional view illustrating an example of a manufacturing method of the semiconductor device according to the ninth embodiment.
Fig. 29D is a cross-sectional view illustrating an example of a manufacturing method of the semiconductor device according to the ninth embodiment.
Fig. 30A is a cross-sectional view illustrating an example of a manufacturing method of the semiconductor device according to the eleventh embodiment.
Fig. 30B is a cross-sectional view illustrating an example of a manufacturing method of the semiconductor device according to the eleventh embodiment.
Fig. 30C is a cross-sectional view illustrating an example of a manufacturing method of the semiconductor device according to the eleventh embodiment.
Fig. 31A is a plan view illustrating an example of a manufacturing method of the semiconductor device according to the eleventh embodiment.
Fig. 31B is a plan view illustrating an example of a manufacturing method of the semiconductor device according to the eleventh embodiment.
Fig. 31C is a plan view illustrating an example of a manufacturing method of the semiconductor device according to the eleventh embodiment.
Fig. 31D is a plan view illustrating an example of a manufacturing method of the semiconductor device according to the eleventh embodiment.
Fig. 32 is a diagram illustrating an example in which the embodiment according to the present technology is used as a CMOS image sensor.

### MODE FOR CARRYING OUT THE INVENTION

Hereinafter, specific embodiments to which the present technology is applied will be described in detail with reference to the drawings. The drawings are schematic or conceptual, and the ratio of each part and the like are not necessarily the same as actual ones. In the description and the drawings, elements similar to those described above with respect to previously described drawings are denoted by the same reference numerals, and detailed descriptions thereof are appropriately omitted.

### (First Embodiment)

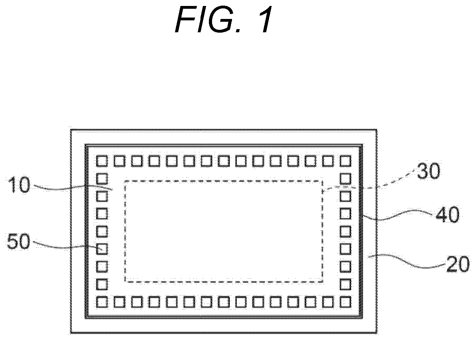

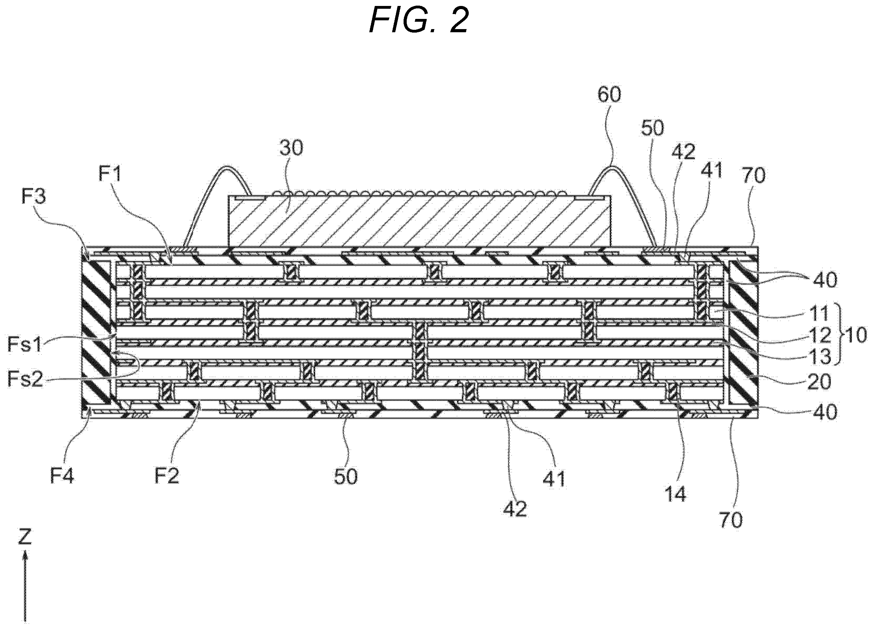

Fig. 1 is a plan view illustrating a configuration example of a semiconductor device according to a first embodiment. Fig. 2 is a cross-sectional view illustrating a configuration example of the semiconductor device according to the first embodiment. Note that Fig. 1 illustrates a positional relationship among a glass substrate 10, a frame-shaped material 20, a semiconductor chip 30, and an insulating film 40, and illustration of other detailed configurations is omitted. The position of the semiconductor chip 30 is indicated by a virtual line.

As illustrated in Fig. 1, the semiconductor chip 30 is mounted on a central portion of the glass substrate 10. The frame-shaped material 20 is provided around the glass substrate 10 so as to continuously cover the entire side surface of the glass substrate 10. The semiconductor chip 30 is not particularly limited, but may be, for example, a complementary metal oxide semiconductor (CMOS) image sensor chip (CMOS image sensor (CIS)). The insulating film 40 as a first insulating film is provided between the side surface of the glass substrate 10 and the inner side surface of the frame-shaped material 20. Furthermore, a plurality of pads 50 is arranged on the surface of the glass substrate 10 so as to surround the periphery of the semiconductor chip 30.

As illustrated in Fig. 2, the glass substrate 10 includes a first surface F1, a second surface F2 opposite to the first surface F1, and a side surface (first side surface) Fs1 between the first surface F1 and the second surface F2. The glass substrate 10 includes a plurality of glass thin plates 11, a wiring layer 12, an insulating film 13, and a through electrode 14.

The plurality of glass thin plates 11 is stacked in the thickness direction (Z direction). The wiring layer 12 is provided between the plurality of glass thin plates 11 adjacent in the Z direction. The insulating film 13 as a fourth insulating film is also provided between the plurality of glass thin plates 11 adjacent in the Z direction. The wiring layer 12 is formed on the surface of each glass thin plate 11 by plating, sputtering, or the like, and processed into an arbitrary layout pattern. For the wiring layer 12, for example, a conductive metal material such as copper is used. The insulating film 13 is provided so as to cover the wiring layer 12 on the surface of each glass thin plate 11. The through electrode 14 penetrates each thin glass thin plate 11 and electrically connects the wiring layer on the front surface of the thin glass thin plate 11 and the wiring layer on the back surface thereof. Similarly to the wiring layer 12, for example, a conductive metal material such as copper is used for the through electrode 14.

The glass substrate 10 is configured by stacking a plurality of glass thin plates 11 having the wiring layer 12 and the insulating film 13. Note that the glass substrate 10 may be a glass stacked substrate obtained by stacking a plurality of glass thin plates 11, or may be a single-layer glass substrate.

The frame-shaped material 20 as a first frame-shaped material is provided so as to surround the periphery of the glass substrate 10. The frame-shaped material 20 has a third surface F3 on the first surface F1 side, a fourth surface F4 on the second surface F2 side, and a first inner side surface Fs2 facing the first side surface Fs1. As the frame-shaped material 20, for example, an insulating material such as glass epoxy resin is used. The frame-shaped material 20 may be copper clad laminate (CCL) provided with a copper film on the surface. The frame-shaped material 20 covers and protects the first side surface Fs1 of the glass substrate 10. Therefore, the mechanical strength of the glass substrate 10 can be improved, and cracking of the glass substrate 10 can be suppressed.

The insulating film 40 is provided between the first side surface Fs1 of the glass substrate 10 and the first inner side surface Fs2 of the frame-shaped material 20. Furthermore, the insulating film 40 is also provided on the first surface F1 of the glass substrate 10 and the third surface F3 of the frame-shaped material 20. Moreover, the insulating film 40 is also provided on the second surface F2 of the glass substrate 10 and the fourth surface F4 of the frame-shaped material 20. For the insulating film 40, for example, an insulating material such as an epoxy-based resin or a polyimide-based resin is used.

The insulating film 40 fills a gap between the glass substrate 10 and the frame-shaped material 20, and covers the front and back surfaces (F1 to F4) of the glass substrate 10 and the frame-shaped material 20. Therefore, the glass substrate 10 is fixed to the frame-shaped material 20. Furthermore, the first surface F1 of the glass substrate 10 and the third surface F3 of the frame-shaped material 20 can be substantially flush, and the second surface F2 of the glass substrate 10 and the fourth surface F4 of the frame-shaped material 20 can be substantially flush.

A wiring layer 42 is provided on the insulating film 40. The wiring layer 42 is provided on the insulating film 40 on the first surface F1 and the second surface F2, and processed into a desired layout pattern. Furthermore, a via 41 penetrating the insulating film 40 is provided. The via 41 electrically connects the wiring layer 42 on the insulating film 40 and the wiring layer 12 on the first surface F1 of the glass substrate 10. For the wiring layer 42 and the via 41, for example, a conductive metal material such as copper is used. In this manner, the insulating film 40 and the wiring layer 42 constitute a redistribution layer. Hereinafter, the insulating film 40, the via 41, and the wiring layer 42 are also referred to as redistribution layers 40 to 42. The redistribution layers 40 to 42 are not limited to a single-layer wiring, and may be a multilayer wiring layer.

The redistribution layers 40 to 42 are also provided on the third surface F3 and the fourth surface F4 of the frame-shaped material 20. That is, the wiring layer 42 is provided on the insulating film 40 on the third surface F3 and the fourth surface F4, and processed into a desired layout pattern. Furthermore, the via 41 penetrating the insulating film 40 may be provided on the third and fourth surfaces F3 and F4 of the frame-shaped material 20.

As described above, according to the present embodiment, the redistribution layers 40 to 42 are provided on the third and fourth surfaces F3 and F4 of the frame-shaped material 20.

An insulating film 70 as a second insulating film is provided on the redistribution layers 40 to 42 on the first surface F1 and the third surface F3. The insulating film 70 is also provided on the redistribution layers 40 to 42 on the second surface F2 and the fourth surface F4. The insulating film 70 covers and protects the redistribution layers 40 to 42. For the insulating film 70, for example, an insulating material such as an epoxy-based resin, a polyimide-based resin, or a solder resist is used.

The pad 50 as a first pad is exposed from the insulating film 70 provided on the first surface F1 and the second surface F2 of the glass substrate 10, and is electrically connected to each wiring layer 42. The pad 50 on the first surface F1 side functions as a bonding pad connected to a metal wire 60. The pad 50 on the second surface F2 side is exposed from the insulating film 70 provided on the second surface F2 of the glass substrate 10, and functions as a land grid array (LGA). Note that a metal bump (not illustrated) may be formed on the pad 50 on the second surface F2 side to form a ball grid array (BGA). Furthermore, the pad 50 may be an electrode for connecting a connector. For the pad 50, for example, a conductive metal material such as copper is used.

The pad 50 on the first surface F1 side is electrically connected to the redistribution layers 40 to 42, and is electrically connected to the pad 50 on the second surface F2 side via the wiring layer 12 in the glass substrate 10 and the through electrode 14. Therefore, the semiconductor chip 30 can receive power supply from a mounting substrate (not illustrated) on the second surface F2 side via the wiring of the glass substrate 10 or transmit a signal to the mounting substrate.

The glass substrate 10, the frame-shaped material 20, the redistribution layers 40 to 42, the pad 50, and the insulating film 70 may be configured as a glass interposer of the semiconductor chip 30.

The semiconductor chip 30 is provided on the insulating film 70 above the first surface F1 of the glass substrate 10. The semiconductor chip 30 is bonded to the insulating film 70 with an adhesive layer (for example, Die Attach Film (DAF)) not illustrated. The metal wire 60 electrically connects the bonding pad of the semiconductor chip 30 and the pad 50. The semiconductor chip 30 is, for example, an imaging device such as a CIS, and is configured using a silicon substrate.

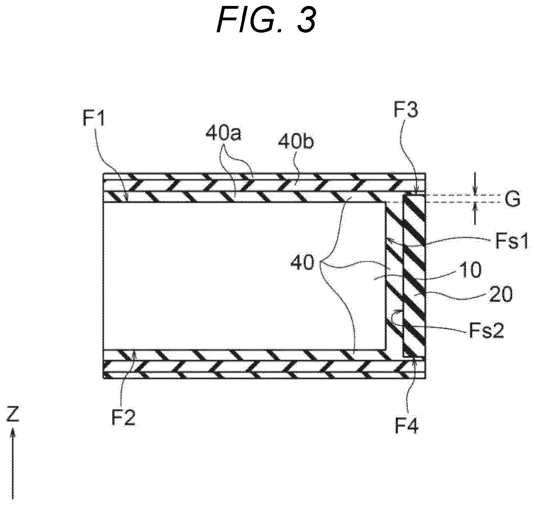

Fig. 3 is a cross-sectional view illustrating a configuration around an end portion of the glass substrate 10. Even if the first surface F1 of the glass substrate 10 and the third surface F3 of the frame-shaped material 20 are shifted in the thickness direction (Z direction), the insulating film 40 fills a step G and can provide a substantially flat and flush surface. Therefore, the wiring layer 42 can be formed on the flat insulating film 40. Furthermore, even when the second surface F2 of the glass substrate 10 and the fourth surface F4 of the frame-shaped material 20 are shifted in the thickness direction (Z direction), the insulating film 40 fills the step to provide a substantially flat and flush surface. Therefore, the wiring layer 42 can be formed on the flat insulating film 40. As a result, disconnection of the wiring layer 42 can be suppressed.

Furthermore, the insulating film 40 on the first and second surfaces F1 and F2 may have a stacked structure in which a glass cloth material 40b is laminated in an insulating material 40a using an epoxy-based resin or a polyimide-based resin. Therefore, while the Young's modulus of the insulating film 40 between the glass substrate 10 and the frame-shaped material 20 is maintained to be relatively low to maintain the buffer function, the Young's modulus of the insulating film 40 on the first and second surfaces F1 and F2 can be increased to enhance the strength and flatness.

As described above, according to the present embodiment, the insulating film 40 can fill the step G due to the difference in thickness between the glass substrate 10 and the frame-shaped material 20 to provide a substantially flush surface on the first surface F1 and the third surface F3. Similarly, the insulating film 40 can provide a substantially flush surface on the second surface F2 and the fourth surface F4. Therefore, the wiring layer 42 can be formed above the glass substrate 10 and the frame-shaped material 20. Furthermore, disconnection of the wiring layer 42 can be suppressed, leading to improvement of reliability.

### (Second Embodiment)

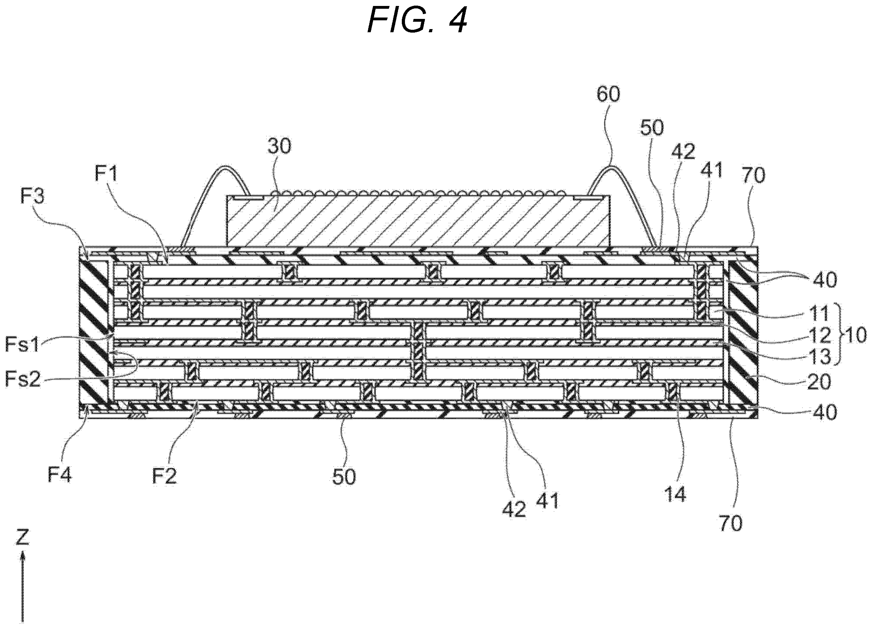

Fig. 4 is a cross-sectional view illustrating a configuration example of a semiconductor device according to a second embodiment. In the second embodiment, the Young's modulus of the insulating film 40 on the second surface F2 and fourth surface F4 side is smaller than the Young's modulus of the insulating film 40 on the first surface F1 and third surface F3 side. For example, the amount of the glass filler contained in the insulating film 40 on the second surface F2 and fourth surface F4 side is made smaller than that contained in the insulating film 40 on the first surface F1 and third surface F3 side. Therefore, the Young's modulus of the insulating film 40 on the second surface F2 and fourth surface F4 side can be reduced.

A mounting substrate (not illustrated) is provided on the second surface F2 and fourth surface F4 side, and the pads 50 on the second surface F2 and fourth surface F4 side are connected to the mounting substrate. The mounting substrate is often a printed substrate using an organic material. In this case, glass as a main component of the glass substrate 10 is not much different in coefficient of thermal expansion (CTE) from silicon as a main component of the semiconductor chip 30, but is greatly different in CTE from an organic material of the mounting substrate. For this reason, a relatively large stress may be applied to the connection part such as the pad 50 on the second surface F2 and fourth surface F4 side. Note that the organic material is larger in CTE than glass or silicon, that is, smaller in Young's modulus.

Therefore, in the second embodiment, the Young's modulus of the insulating film 40 on the second surface F2 and fourth surface F4 side is reduced to be close to the Young's modulus of the organic material. Therefore, the stress applied to the bonding portion between the pad 50 and the mounting substrate can be relaxed, and the reliability of the semiconductor device can be improved.

Other configurations of the second embodiment may be similar to those of the first embodiment. Therefore, the second embodiment can obtain effects similar to those of the first embodiment.

### (Third Embodiment)

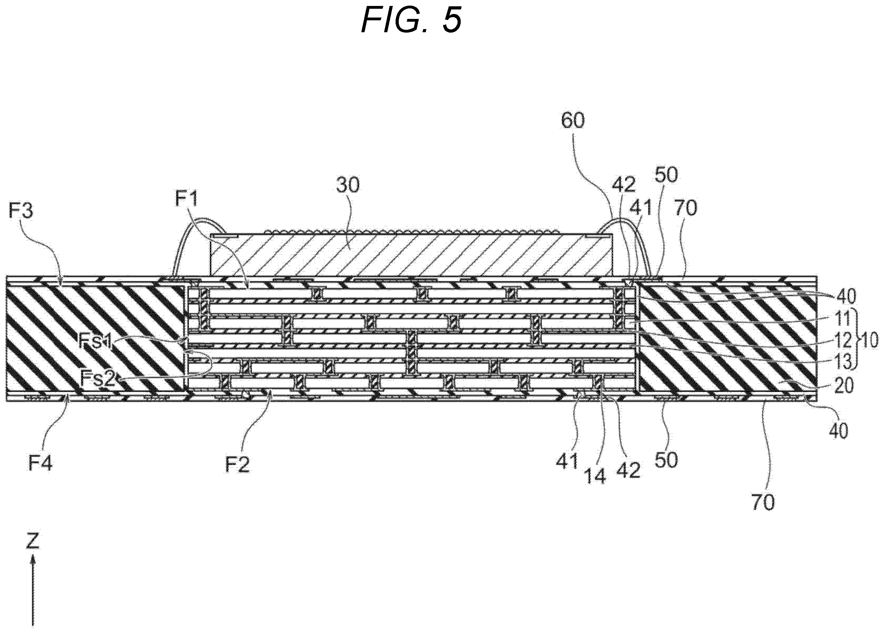

Fig. 5 is a cross-sectional view illustrating a configuration example of a semiconductor device according to a third embodiment. In the third embodiment, not only the redistribution layers 40 to 42 but also the pad 50 is provided on the third surface F3 and/or the fourth surface F4 of the frame-shaped material 20. The pad (first pad) 50 on the third surface F3 side is exposed from the insulating film 70 and electrically connected to the redistribution layers 40 to 42 on the third surface F3 side. The pad (second pad) 50 on the fourth surface F4 side is exposed from the insulating film 70 and electrically connected to the redistribution layers 40 to 42 on the fourth surface F4 side.

The pad 50 on the third surface F3 side is electrically connected to the pad 50 on the fourth surface F4 side via the wiring layer 12 and the through electrode 14 in the glass substrate 10. Therefore, the semiconductor chip 30 can receive power supply from a mounting substrate (not illustrated) on the fourth surface F4 side via the wiring of the glass substrate 10 or transmit a signal to the mounting substrate.

According to the present embodiment, even if the first surface F1 of the glass substrate 10 and the third surface F3 of the frame-shaped material 20 are shifted in the thickness direction (Z direction), the insulating film 40 fills a step G and can provide a substantially flat and flush surface. Furthermore, even when the second surface F2 of the glass substrate 10 and the fourth surface F4 of the frame-shaped material 20 are shifted in the thickness direction (Z direction), the insulating film 40 fills the step to provide a substantially flat and flush surface. In particular, it is difficult to control the thickness of the glass substrate 10 on which the glass thin plate 11 is stacked. However, the insulating film 40 can fill the step between the first surface F1 of the glass substrate 10 and the third surface F3 of the frame-shaped material 20 to provide a substantially flat and flush surface. Furthermore, the insulating film 40 can fill the step between the second surface F2 of the glass substrate 10 and the fourth surface F4 of the frame-shaped material 20 to provide a substantially flat and flush surface. Therefore, the redistribution layers 40 to 42 can be easily provided not only on the first surface F1 and the second surface F2 of the glass substrate 10 but also on the third surface F3 and the fourth surface F4 of the frame-shaped material 20 while maintaining high reliability. Furthermore, the pad 50 can also be easily provided on the third surface F3 and the fourth surface F4 of the frame-shaped material 20 while maintaining high reliability.

The glass substrate 10 is more expensive than the frame-shaped material 20. In particular, the glass substrate 10 on which the glass thin plate 11 is stacked tends to be more expensive. On the other hand, although the glass substrate 10 is preferable for mounting the semiconductor chip 30 from the viewpoint of CTE and flatness, other wirings and pads are not necessarily mounted on the glass substrate 10.

Therefore, in the third embodiment, the semiconductor chip 30 is provided on the glass substrate 10, and the redistribution layers 40 to 42 and the pad 50 are provided on the glass substrate 10 and the frame-shaped material 20. Therefore, the redistribution layers 40 to 42 and the pad 50 can be disposed on the first to fourth surfaces F1 to F4 including the glass substrate 10 and the frame-shaped material 20. As a result, the degree of freedom in the arrangement of the redistribution layers 40 to 42 and the pad 50 can be improved. Furthermore, the size of the glass substrate 10 can be reduced in accordance with the size of the semiconductor chip 30, and the manufacturing cost can be reduced.

By improving the degree of freedom in the arrangement of the pad 50 on the first and third surfaces F1 and F3, the degree of freedom in wiring of the metal wire 60 is improved. By improving the degree of freedom in the arrangement of the pad 50 on the second and fourth surfaces F2 and F4, the degree of freedom in the arrangement (layout design) of the LGA or BGA is improved, and it is possible to cope with various mounting substrates. This is effective in a case where the number of pins has increased with the increase in the number of functions of the semiconductor chip 30.

Other configurations of the third embodiment may be similar to those of the first or second embodiment. Therefore, the third embodiment can obtain effects similar to those of the first or second embodiment.

As described above, the insulating film 40 provides a substantially flush surface on the first surface F1 and the third surface F3, and provides a substantially flush surface on the second surface F2 and the fourth surface F4. Therefore, the length of the metal wire 60 can be shortened. As a result, the impedance between the semiconductor chip 30 and the pad 50 on the second surface F2 side can be reduced, leading to improvement of the reliability of the semiconductor device.

### (Fourth Embodiment)

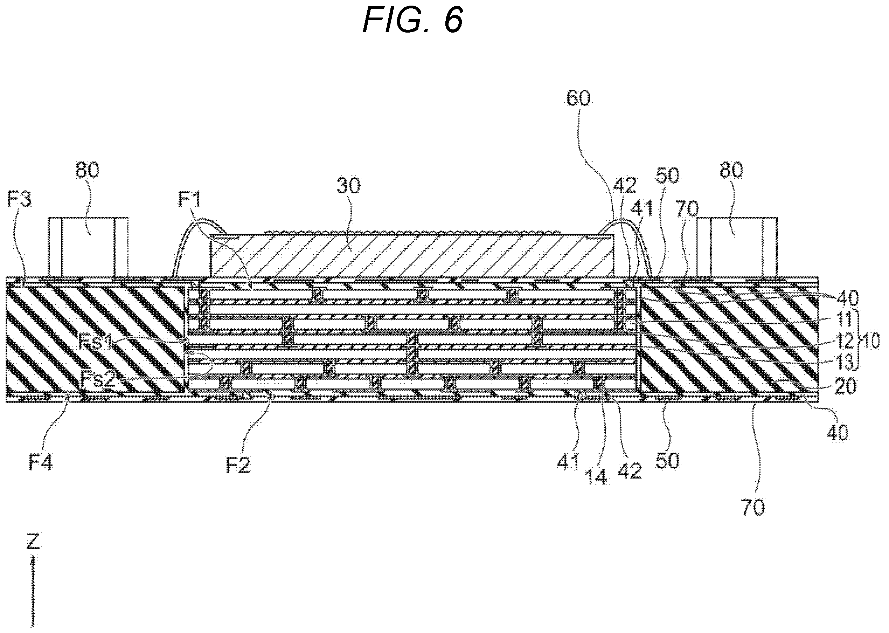

Fig. 6 is a cross-sectional view illustrating a configuration example of a semiconductor device according to a fourth embodiment. In the fourth embodiment, an electronic component 80 is provided on the third surface F3 of the frame-shaped material 20. The electronic component 80 may be, for example, an electronic component such as a capacitor, an inductor, or a resistor. The electronic component 80 is electrically connected to the redistribution layers 40 to 42 via the pad 50.

As described above, the electronic component 80 other than the semiconductor chip 30 may be provided on the third surface F3 of the frame-shaped material 20 that is less expensive than the glass substrate 10. Therefore, the degree of freedom of the arrangement (layout design) of the electronic component 80 is improved. Furthermore, the manufacturing cost can be reduced by reducing the size of the glass substrate 10. Moreover, in a case where the electronic component cannot be mounted on the second and fourth surfaces F2 and F4, the electronic component can be disposed on the third surface F3 side.

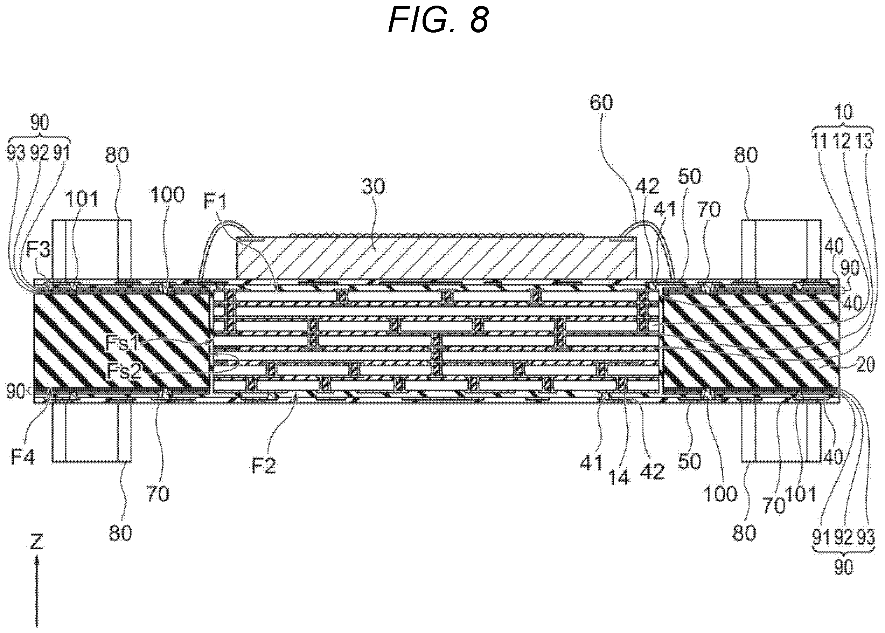

As illustrated in Fig. 8, in a case where an electronic component can be mounted on the fourth surface F4 of the frame-shaped material 20, the electronic component 80 may be provided on the fourth surface F4 of the frame-shaped material 20. In this case, the electronic component 80 is electrically connected to the redistribution layers 40 to 42 via the pad 50 on the fourth surface F4 side.

Other configurations of the fourth embodiment may be similar to the configurations of any of the first to third embodiments. Therefore, the fourth embodiment can obtain effects similar to those of the first to third embodiments.

### (Fifth Embodiment)

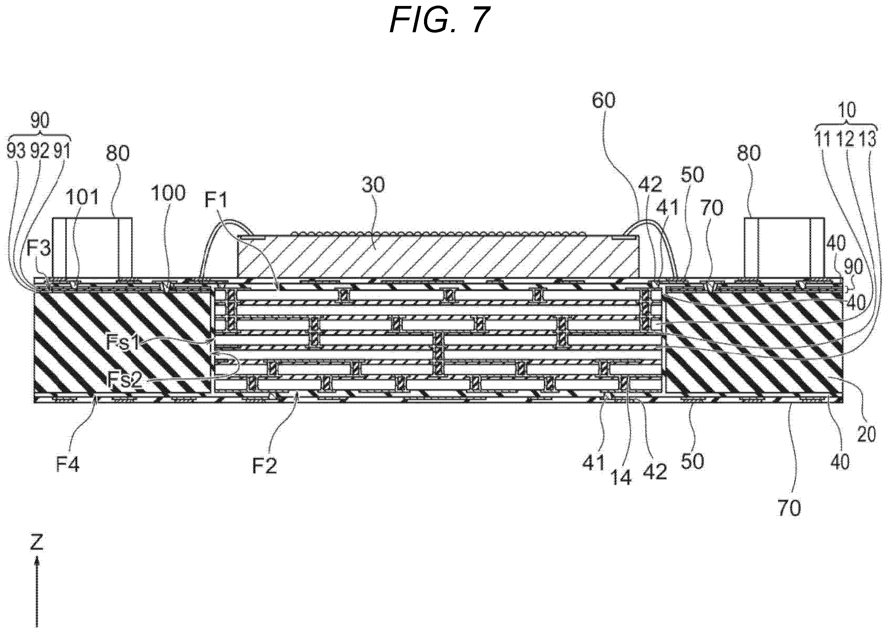

Fig. 7 is a cross-sectional view illustrating a configuration example of a semiconductor device according to a fifth embodiment. The fifth embodiment is similar to the fourth embodiment in that the electronic component 80 is provided on the third surface F3 of the frame-shaped material 20. The fifth embodiment is different from the fourth embodiment in that a capacitor 90 is further provided on the third surface F3 of the frame-shaped material 20. The capacitor 90 as a first capacitive element may be a thin film capacitor (for example, 1 Metal-Insulator-Metal (MIM) capacitor) in which a conductive film 91, an insulating film 92, and a conductive film 93 are stacked on the third surface F3. The capacitor 90 is provided between the third surface F3 of the frame-shaped material 20 and the electronic component 80 or between the third surface F3 of the frame-shaped material 20 and the insulating film 40.

The two electrodes (91, 93) of the capacitor 90 are electrically connected to the pad 50 or the electronic component 80 via the redistribution layers 40 to 42, and are electrically connected to the semiconductor chip 30 and/or a mounting substrate (not illustrated). A via 100 is provided so as to penetrate the insulating film 40, the conductive film 91, and the insulating film 92 in order to connect the lower electrode (93) of the capacitor 90 and the redistribution layers 40 to 42. A via 101 is provided so as to penetrate the insulating film 40 in order to connect the upper electrode (91) of the capacitor 90 and the redistribution layers 40 to 42. For the conductive films 91 and 93 and the vias 100 and 101, for example, a conductive metal material such as copper or tungsten is used. For the insulating film 92, for example, a material similar to that of the insulating film 40 is used.

In this manner, the capacitor 90 and the electronic component 80 may be provided in the frame-shaped material 20. The capacitor 90 may be formed in advance in the frame-shaped material 20 before the glass substrate 10 is fitted into the frame-shaped material 20. Furthermore, the capacitor 90 may be provided in the redistribution layers 40 to 42 on the insulating film 40.

In a case where the capacitor 90 is used for power storage, stable power can be supplied to the electronic component 80 or the semiconductor chip 30. Furthermore, in a case where the capacitor 90 is used as a filter for signal transmission, noise can be removed from the signal. Therefore, the capacitor 90 can improve power integrity (PI) or signal integrity (SI).

### (Modifications)

Fig. 8 is a cross-sectional view illustrating a modification of the fourth or fifth embodiment. In the present modification, the electronic component 80 is provided not only on the third surface F3 side but also on the fourth surface F4 side. In this case, the electronic component 80 is electrically connected to the redistribution layers 40 to 42 on the fourth surface F4 side via the pad 50 on the fourth surface F4 side.

Moreover, the capacitor 90 is provided not only on the third surface F3 side of the frame-shaped material 20 but also on the fourth surface F4 side. The plurality of capacitors 90 may be applied to respective applications of power supply and signal transmission. In this case, both the power integrity and the signal integrity can be improved.

Furthermore, an electronic component other than the capacitor may be provided on the third surface F3 and/or the fourth surface F4 of the frame-shaped material 20. Therefore, more functions can be implemented in the frame-shaped material 20.

### (Sixth Embodiment)

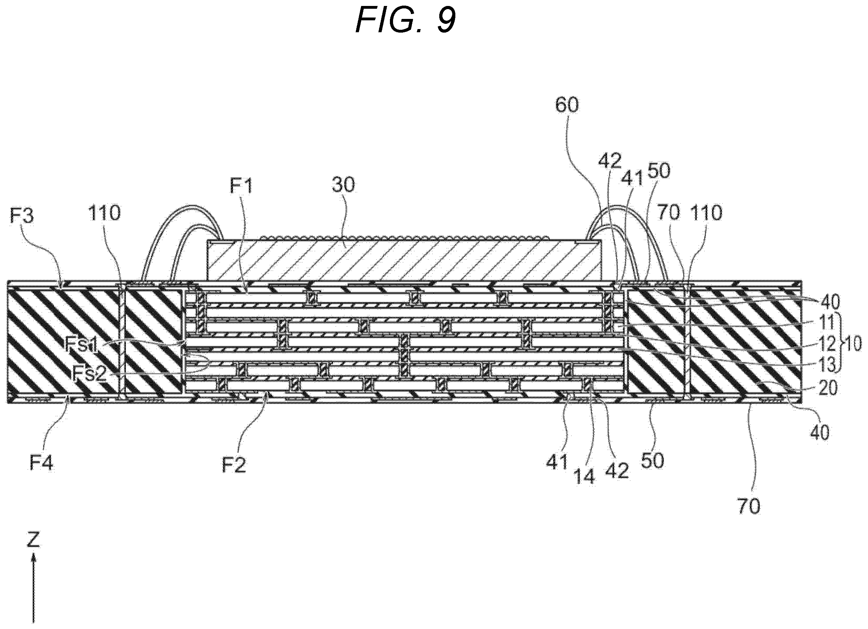

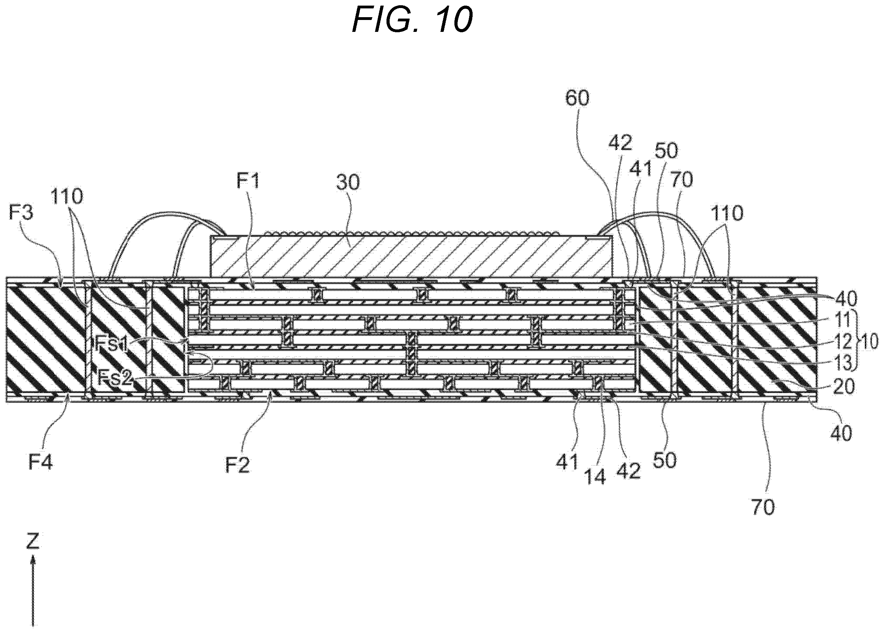

Figs. 9 and 10 are cross-sectional views illustrating configuration examples of a semiconductor device according to a sixth embodiment. In the sixth embodiment, a through electrode 110 is provided so as to penetrate between the third surface F3 and the fourth surface F4 of the frame-shaped material 20. One end of the through electrode 110 is electrically connected to the redistribution layers 40 to 42 on the third surface F3 side, and the other end is electrically connected to the redistribution layers 40 to 42 on the fourth surface F4 side. The through electrode 110 can electrically connect the redistribution layers 40 to 42 on the first and third surfaces F1 and F3 sides and the redistribution layers 40 to 42 on the second and fourth surfaces F2 and F4 sides with low impedance without interposing the wiring layer in the glass substrate 10.

In Fig. 9, one through electrode 110 is provided on each side of the frame-shaped material 20. In Fig. 10, two through electrodes 110 are provided on each side of the frame-shaped material 20. The number of the through electrodes 110 provided in the frame-shaped material 20 is not particularly limited, and may be arbitrary.

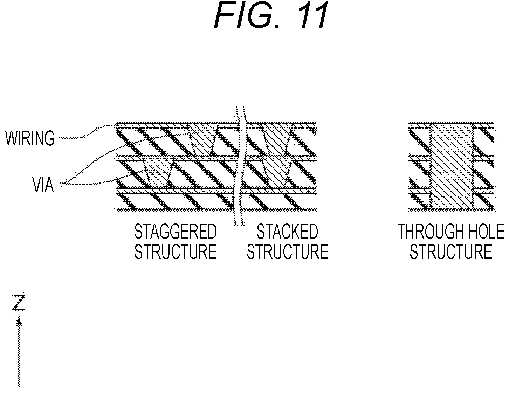

The through electrode 110 can be formed by embedding a conductive metal material (for example, copper, tungsten, and the like) in a through hole provided between the third surface F3 and the fourth surface F4 of the frame-shaped material 20. The through electrode 110 may have such a through hole structure, a staggered structure, a stacked via structure, or the like. Fig. 11 is a cross-sectional view illustrating an example of the staggered structure, the stacked via structure, and the through hole structure. The staggered structure is a structure in which a plurality of layers of vias shifted in a direction intersecting the Z direction is connected by wiring. The stacked via structure is a structure in which a plurality of vias stacked in the Z direction is directly connected. The through hole structure is a structure in which a conductive material is collectively embedded in the through holes formed in a plurality of insulating films. Alternatively, the through hole structure may be a structure in which the inner side surface is covered with a conductive material and an insulating material is embedded inside the conductive material.

The through electrode 110 connects the redistribution layers 40 to 42 on the first and third surfaces F1 and F3 side and the redistribution layers 40 to 42 on the second and fourth surfaces F2 and F4 side with low resistance. Therefore, in a case where the through electrode 110 is used for power supply, the through electrode 110 can provide power supply with less waste to the semiconductor chip 30 while suppressing a decrease in voltage. In a case where the through electrode 110 is used for signal transmission, since the through electrode 110 has a small impedance loss, a signal can be transmitted at high speed and with low noise.

Furthermore, in a case where the layout of the pad 50 and the redistribution layers 40 to 42 are not complicated, a single-layer glass substrate may be used for the glass substrate 10, and the redistribution layers 40 to 42 on the first surface F1 side and the redistribution layers 40 to 42 on the second surface F2 side may be all connected via the through electrode 110 of the frame-shaped material 20. Note that the arrangement of the pads 50 can be handled by forming the redistribution layers 40 to 42 into a multilayer wiring structure.

Other configurations of the sixth embodiment may be similar to the configurations of any of the first to fifth embodiments. Therefore, the sixth embodiment can obtain the effects similar to those of any of the first to fifth embodiments.

### (Seventh Embodiment)

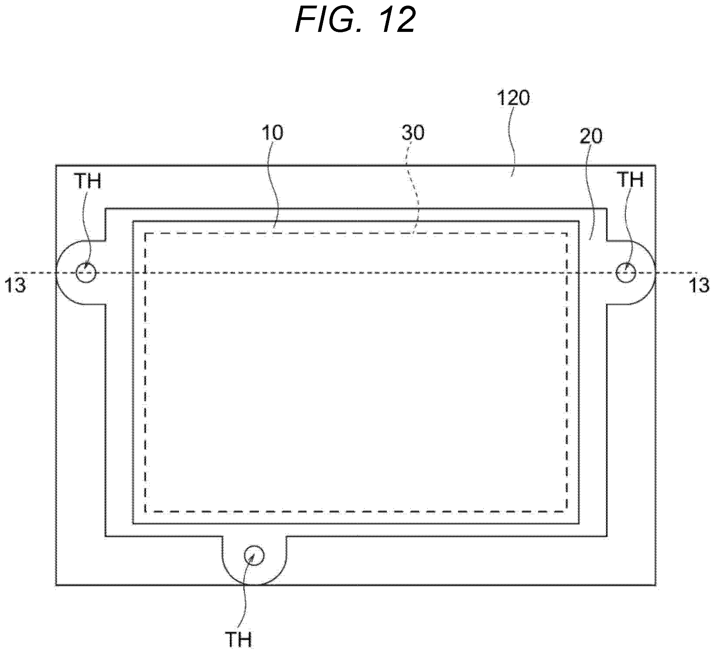

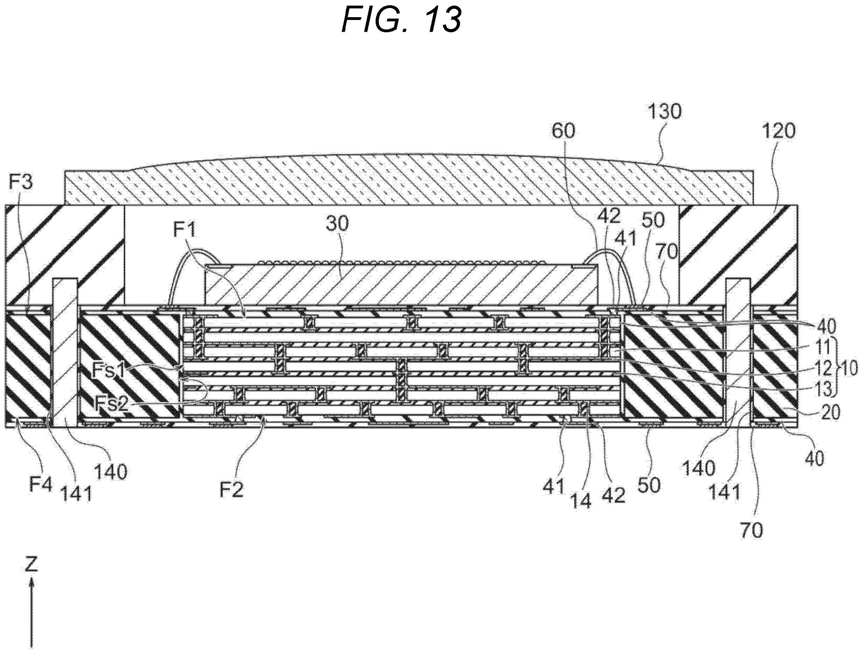

Fig. 12 is a schematic plan view illustrating a configuration example of a semiconductor device according to a seventh embodiment. Fig. 13 is a cross-sectional view illustrating a configuration example of a semiconductor device according to the seventh embodiment. Fig. 13 corresponds to a cross section taken along line 13-13 of Fig. 12.

As illustrated in Fig. 12, the semiconductor chip 30 is provided so as to overlap on the glass substrate 10. A fastening hole TH is provided in a part of the frame-shaped material 20. A frame 120 is provided so as to overlap the fastening hole TH of the frame-shaped material 20. The fastening hole TH may be formed in the frame-shaped material 20 using a drill or a laser. Furthermore, the shape of the frame-shaped material 20 can be freely designed by processing with a router or the like.

As illustrated in Fig. 13, in the seventh embodiment, the frame 120 and a lens 130 are fixed to the frame-shaped material 20 by fitting a fastening member 140 into the fastening hole TH and the frame 120. Similarly to the frame-shaped material 20, the frame 120 is a frame-shaped member provided on the third surface F3 of the frame-shaped material 20 so as to surround the glass substrate 10 and the semiconductor chip 30. For the frame 120, for example, an insulating material such as resin is used. In the seventh embodiment, the lens 130 is fixed to the frame 120, but the frame 120 may be a mounting substrate (printed substrate), a lens module, or a housing (not illustrated) of the device.

The fastening member 140 is fitted into the fastening hole TH and the fastening hole provided in the frame 120 to fix the frame 120 to the frame-shaped material 20. The fastening member 140 may be, for example, a screw or the like. A sleep, an insert, and a helisert 141 may be provided between the fastening member 140 and the inner wall of the fastening hole of the frame-shaped material 20 and the frame 120 as necessary.

The lens 130 is provided on the frame 120 and disposed so as to cover the upper portion of the semiconductor chip 30. The lens 130 is only required to be bonded to the frame 120 with an adhesive or the like. Therefore, the lens 130 is fixed to the light receiving surface of the semiconductor chip 30, and is modularized as an integrated semiconductor device. The lens 130 can collect light on the light receiving surface of the semiconductor chip 30.

Other configurations of the seventh embodiment may be the same as the configurations of any of the first to sixth embodiments. Therefore, the seventh embodiment can obtain the effects similar to those of any of the first to sixth embodiments.

### (Eighth Embodiment)

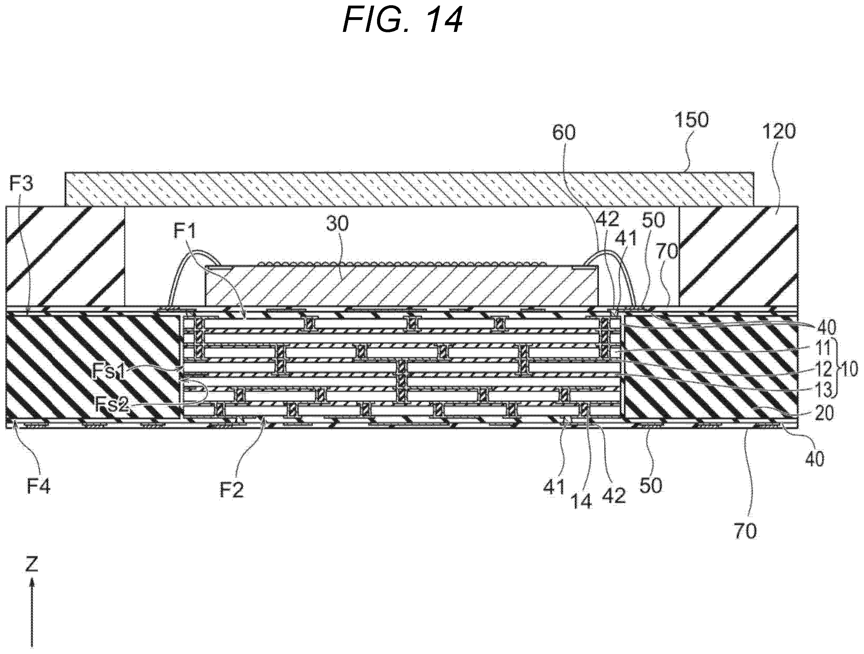

Fig. 14 is a cross-sectional view illustrating a configuration example of a semiconductor device according to an eighth embodiment. In the eighth embodiment, the frame 120 is bonded onto the insulating film 70 on the third surface F3 side of the frame-shaped material 20. The frame 120 is provided so as to surround the periphery of the semiconductor chip 30 provided on the glass substrate 10. A sealing glass 150 is bonded onto the frame 120 as a protective member. The sealing glass 150 is disposed above the semiconductor chip 30. The frame 120 and the sealing glass 150 are fixed to the frame-shaped material 20 and the glass substrate 10. Therefore, the frame 120 and the sealing glass 150 can protect the semiconductor chip 30. Electronic components other than the semiconductor chip 30 may be disposed inside the frame 120.

Other configurations of the eighth embodiment may be similar to the configurations of any of the first to sixth embodiments. Therefore, the eighth embodiment can obtain the effects similar to those of any of the first to sixth embodiments.

### (Ninth Embodiment)

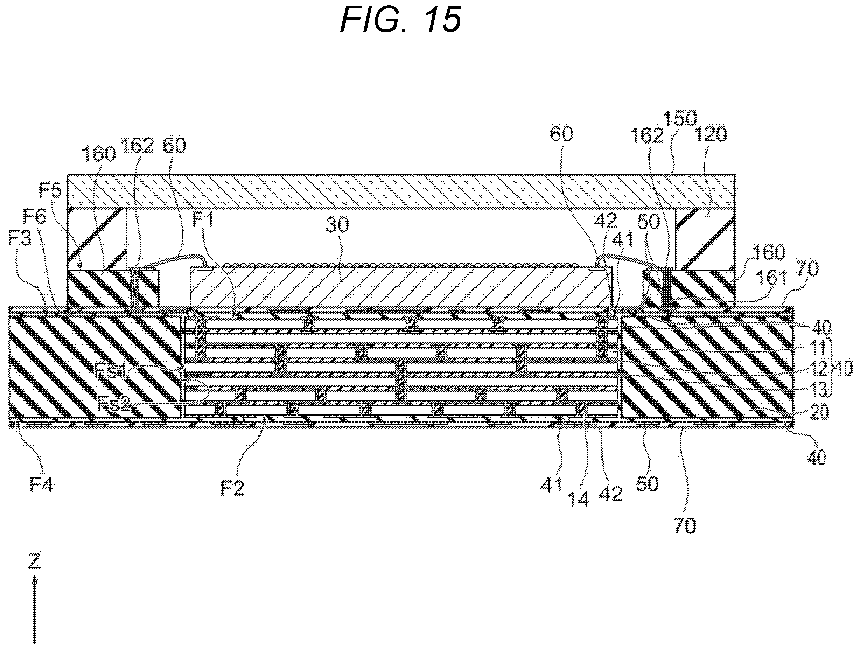

Fig. 15 is a cross-sectional view illustrating a configuration example of a semiconductor device according to a ninth embodiment. In the ninth embodiment, a frame-shaped material 160 as a second frame-shaped material is provided on the frame-shaped material 20, and the frame 120 is provided on the frame-shaped material 160.

The frame-shaped material 160 has a fifth surface F5 and a sixth surface F6 opposite to the fifth surface F5. The fifth surface F5 is on the frame 120 side and is bonded to the frame 120. The sixth surface F6 faces the third surface F3 of the frame-shaped material 20, and is bonded onto the insulating film 70.

The frame-shaped material 160 includes a through electrode 161 penetrating between the fifth surface F5 and the sixth surface F6, and a pad 162 provided on the fifth surface F5 and connected to the through electrode 161. The through electrode 161 electrically connects the pad 50 and the pad 162.

The metal wire 60 is connected between the pad 162 and the pad on the semiconductor chip 30, and electrically connects between the semiconductor chip 30 and the through electrode 161.

### (Tenth Embodiment)

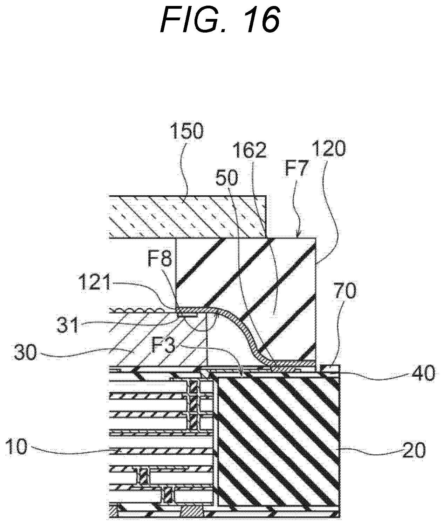

Fig. 16 is a cross-sectional view illustrating a configuration example of a semiconductor device according to a tenth embodiment. In the tenth embodiment, the frame 120 includes a seventh surface F7 and an eighth surface F8 opposite to the seventh surface F7. A conductive film 121 is provided on the eighth surface F8. The eighth surface F8 is formed in a curved surface shape so as to connect a pad 31 on the surface of the semiconductor chip 30 and a pad 50 on the third surface F3 of the frame-shaped material 20. The conductive film 121 as a third conductive film is provided on the eighth surface F8, and electrically connects the pad 31 and the pad 50 along the eighth surface F8. For the conductive film 121, for example, a conductive metal material such as copper or gold is used.

The conductive film 121 is formed on the eighth surface F8 by plating, sputtering, or the like, and processed using a lithography technique and an etching technique. Therefore, the conductive film 121 can be formed in advance on the eighth surface F8 of the frame 120.

Since the conductive film 121 is provided in advance on the eighth surface F8 of the frame 120 and patterned, the conductive film 121 can electrically connect the pad 31 and the pad 50 only by mounting the frame 120 on the semiconductor chip 30 and the frame-shaped material 20. Since the metal wire 60 is not used, the wire bonding process is omitted. As a result, the manufacturing process of the semiconductor device is shortened, and the reliability is improved. Furthermore, it is not necessary to draw out the metal wire 60 long, and the conductive film 121 can connect the pad 31 and the pad 50 with a short distance. Therefore, this makes it easy to suppress the impedance of the wiring low and to adapt the impedance matching to, for example, 50 ohms in the transmission of the high frequency signal.

Moreover, since the conductive film 121 is provided on the curved surface of the frame 120, disconnection is unlikely to occur. The conductive film 121 is not exposed to the space in the frame 120 and the sealing glass 150 unlike the gold wire. Therefore, the incident light is hardly diffusely reflected by the conductive film 121, and the diffusely reflected light can be suppressed from entering the semiconductor chip 30.

Other configurations of the tenth embodiment may be similar to the configurations of any of the first to ninth embodiments. Therefore, the tenth embodiment can obtain the effects of any of the first to ninth embodiments.

### (Eleventh Embodiment)

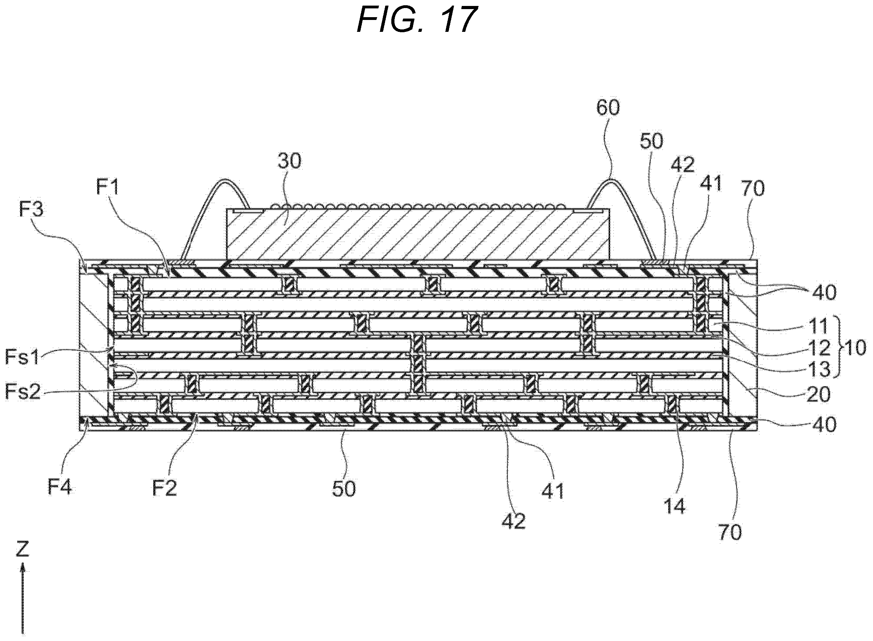

Fig. 17 is a cross-sectional view illustrating a configuration example of a semiconductor device according to an eleventh embodiment. In the eleventh embodiment, the frame-shaped material 20 includes a material having higher heat dissipation than the glass substrate 10. As the frame-shaped material 20, for example, a metal material such as copper or tungsten, carbon graphite, ceramics, silicon, or the like is used. The frame-shaped material 20 has a third surface F3 on the first surface F1 side, a fourth surface F4 on the second surface F2 side, and a first inner side surface Fs2 facing the first side surface Fs1. The frame-shaped material 20 is provided so as to surround the periphery of the glass substrate 10, and has higher heat dissipation than the glass substrate 10. The frame-shaped material 20 can efficiently diffuse heat radiated from all sides of the glass substrate 10 and improve cooling efficiency of the glass substrate 10.

Other configurations of the eleventh embodiment may be similar to the configurations of any of the first to tenth embodiments. Therefore, the eleventh embodiment can obtain the effects of any of the first to tenth embodiments.

### (Glass Substrate 10)

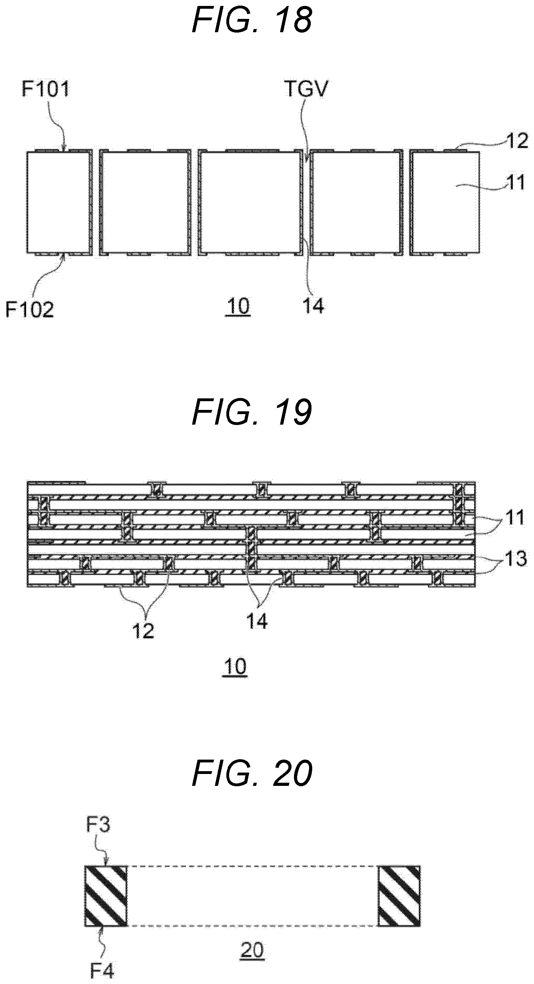

Figs. 18 and 19 are cross-sectional views illustrating examples of the glass substrate 10. Fig. 18 illustrates a single-layer glass substrate 10. A through hole TGV (Through Glass Via) is formed in the glass thin plate 11 using a drill or the like. Next, the material of the wiring layer 12 is formed on a front surface F101 and a back surface F102 of the glass thin plate 11 using plating, sputtering, or the like. At this time, the material of the wiring layer 12 is also formed on the inner wall of the through hole TGV of the glass thin plate 11. The material of the wiring layer 12 may fill the entire through hole TGV. Therefore, the through electrode 14 is formed. Next, the material of the wiring layer 12 on the glass thin plate 11 is processed using a lithography technique and an etching technique to form the wiring layer 12. Therefore, the single-layer glass substrate 10 is formed.

Fig. 19 illustrates the glass substrate 10 in which a plurality of thin glass thin plates 11 is stacked. The through electrode 14 and the wiring layer 12 are formed on the glass thin plate 11 in advance. While the thin glass thin plate 11 and the insulating film 13 are alternately stacked, the wiring layer 12 of the thin glass thin plate 11 is connected to the wiring layer 12 or the through electrode 14 of another thin glass thin plate 11. Therefore, the glass substrate 10 illustrated in Fig. 19 is formed.

### (Frame-Shaped Material 20)

Figs. 20 to 22 are cross-sectional views illustrating examples of the frame-shaped material 20. Fig. 20 illustrates the frame-shaped material 20 used in the first embodiment and the like. The frame-shaped material 20 is obtained by, for example, hollowing out the central portion of a substantially rectangular glass epoxy substrate using a CO₂ laser, a UV laser, a router, or the like. A copper clad laminate (CCL) substrate in which a metal film of copper or the like is provided on the third and fourth surfaces F3 and F4 of the frame-shaped material 20 may be used. In this case, it is preferable to form an alignment mark when arranging the glass substrate 10 inside the frame-shaped material 20.

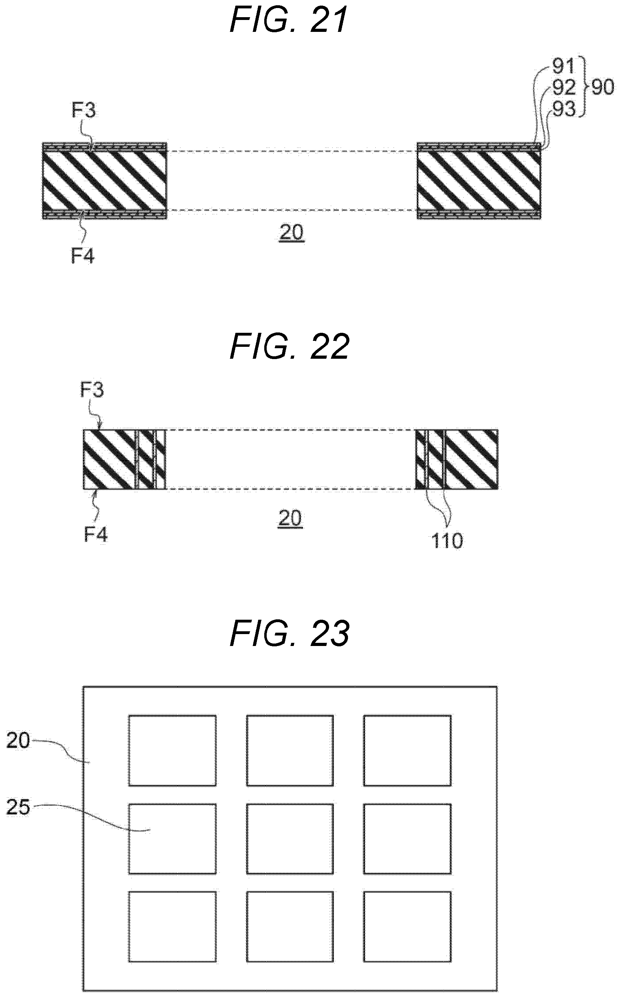

Fig. 21 illustrates the frame-shaped material 20 used in the fifth embodiment. In the frame-shaped material 20, the capacitor 90 is formed in advance. The capacitor 90 is formed by sequentially stacking the conductive film 93, the insulating film 92, and the conductive film 91 on the third and fourth surfaces F3 and F4 of the frame-shaped material 20.

Fig. 22 illustrates the frame-shaped material 20 used in the sixth embodiment. The through electrode 110 is formed in advance in the frame-shaped material 20. The through electrode 110 penetrates between the third surface F3 and the fourth surface F4 of the frame-shaped material 20 to form a path of the electric wiring. As described above, the through electrode 110 may have any of a staggered structure, a stacked via structure, and a through hole structure. Furthermore, the through electrode 110 may be formed by a filling method in which the entire through hole is filled with a conductive material, or may be formed by a conformal method in which a film of a conductive material is formed only on the inner wall of the through hole.

Fig. 23 is a plan view illustrating a configuration of the frame-shaped material 20 before dicing. The frame-shaped material 20 is configured by a grid-like frame. The frame-shaped material 20 has a plurality of substantially rectangular space portions 25 hollowed out to a size slightly larger than the size of the glass substrate 10. When the semiconductor device is manufactured, the glass substrate 10 is disposed in the space portion 25.

### (Manufacturing Method)

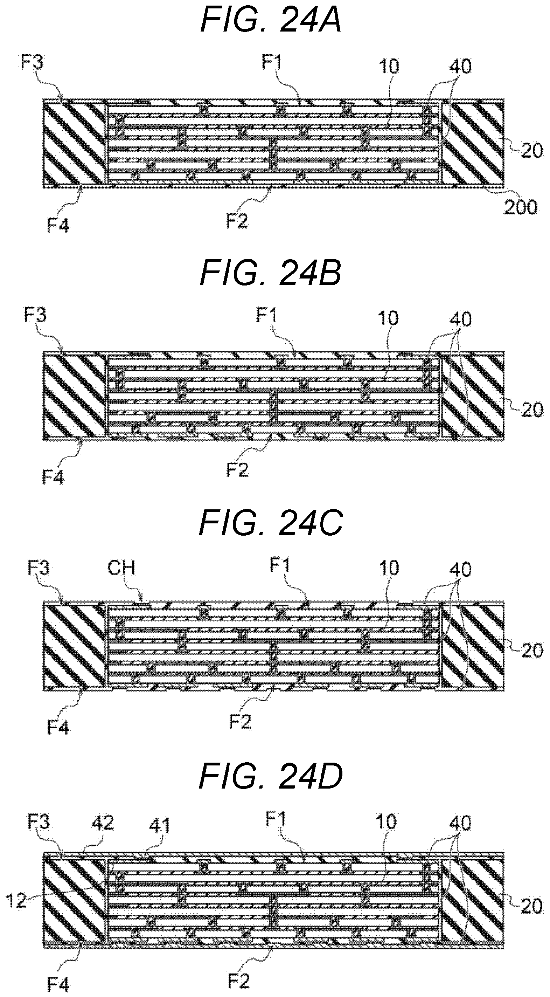

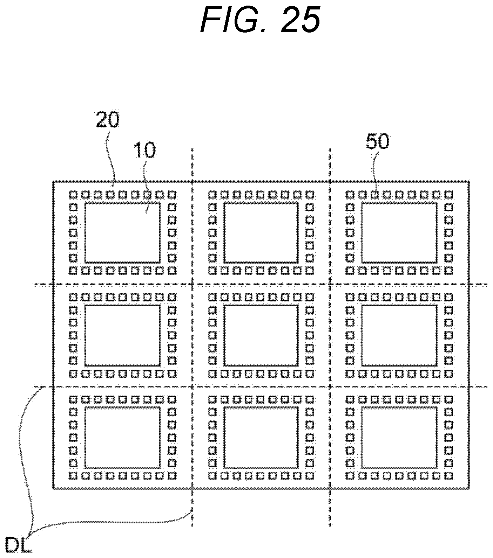

Figs. 24A to 24G, 27, and 28 are cross-sectional views illustrating examples of the manufacturing method of the semiconductor device according to the first embodiment. Fig. 25 is a plan view illustrating an example of the manufacturing method of the semiconductor device. The frame-shaped material 20 has the space portion 25 surrounded by the first inner side surface Fs2.

As illustrated in Fig. 24A, the frame-shaped material 20 of Fig. 23 is bonded onto a tape 200, and the glass substrate 10 is disposed in the space portion 25 of the frame-shaped material 20. The glass substrate 10 is disposed in the space portion 25 of the frame-shaped material 20 such that the first side surface Fs1 and the first inner side surface Fs2 of the frame-shaped material 20 face each other. Next, as a material of the insulating film 40, for example, a thermosetting resin sheet is attached onto the first and third surfaces F1 and F3 and softened. Therefore, the thermosetting resin enters the gap between the frame-shaped material 20 and the glass substrate 10, and fills the step between the first surface F1 of the glass substrate 10 and the third surface F3 of the frame-shaped material 20 to planarize the first surface F1 and the third surface F3. Thereafter, the insulating film 40 is cured by heat treatment. Viscosity, thickness, and lamination conditions of the insulating film 40 are selected as necessary.

Next, as illustrated in Fig. 24B, the insulating film 40 is also formed on the second and fourth surfaces F2 and F4 side and planarized. Therefore, the glass substrate 10 is fixed to and integrated with the frame-shaped material 20. Furthermore, the first surface F1 of the glass substrate 10 and the third surface F3 of the frame-shaped material 20 are substantially planarized, and the second surface F2 of the glass substrate 10 and the fourth surface F4 of the frame-shaped material 20 are substantially planarized. Note that after the insulating film 40 is attached to both surfaces of the first to fourth surfaces F1 to F4, the insulating films 40 on both surfaces may be collectively cured by heat treatment.

Next, as illustrated in Fig. 24C, a part of the insulating film 40 is removed using a UV laser, a CO₂ laser, or the like to form a contact hole CH.

Next, as illustrated in Fig. 24D, the wiring layer 42 is formed on the insulating film 40 on the first to fourth surfaces F1 to F4 by using electroless plating, electrolytic plating, sputtering, or a combination thereof. The material of the wiring layer 42 is connected to the wiring layer 12 exposed through the contact hole CH to form the via 41.

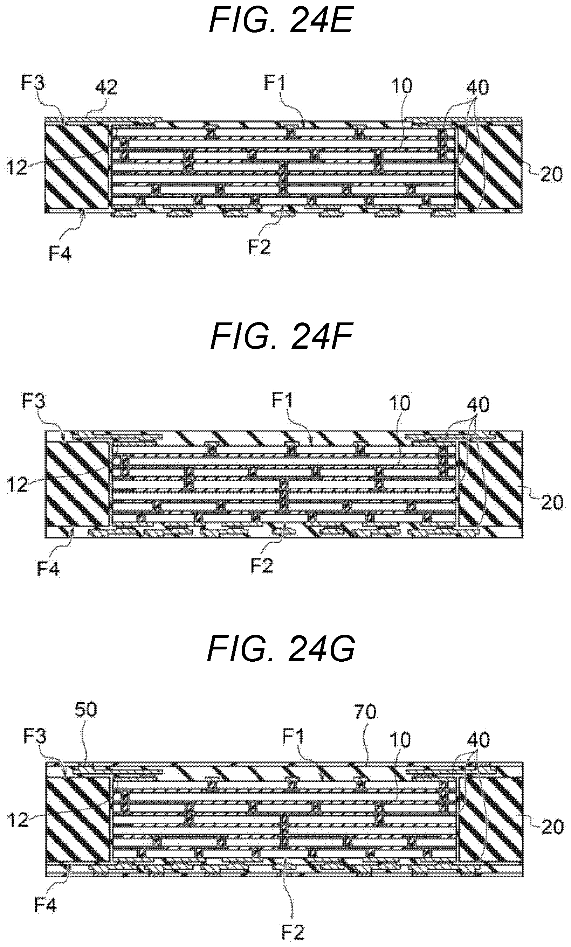

Next, as illustrated in Fig. 24E, the wiring layer 42 is processed using a lithography technique and an etching technique. Since the wiring layer 42 is patterned on the planarized insulating film 40, it can be processed into an arbitrary layout. Furthermore, the wiring layer 42 can be formed not only on the first and second surfaces F1 and F2 of the glass substrate 10 but also on the third and fourth surfaces F3 and F4 of the frame-shaped material 20.

Next, as illustrated in Fig. 24F, the insulating film 40 is further deposited on the wiring layer 42, and the via 41 and the wiring layer 42 are further formed on the insulating film 40. In this manner, the redistribution layers 40 to 42 are formed.

Next, as illustrated in Fig. 24G, the insulating film 70 is formed on the redistribution layers 40 to 42. Next, the insulating film 70 is processed using a lithography technique and an etching technique. For example, a solder resist is used for the insulating film 70. The insulating film 70 may be either the Solder Mask Defined (SMD) or the Non Solder Mask Defined (NSMD).

Next, the pad 50 is formed at a portion where the insulating film 70 is removed and the wiring layer 42 is exposed. For the pad 50, for example, a stacked film of Ni, Pd, and Au is used.

Next, as illustrated in Fig. 25, the frame-shaped material 20 is diced along a dicing line DL using blade dicing, router processing, laser processing, or the like to singulate the glass substrate 10 and the frame-shaped material 20. Therefore, a glass interposer is formed.

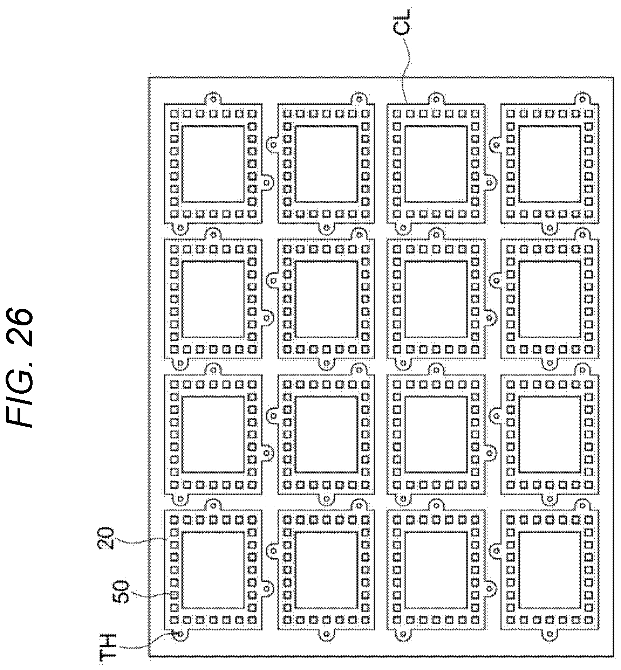

Fig. 26 is a plan view illustrating an example of a manufacturing method of the semiconductor device according to the seventh embodiment. The frame-shaped material 20 according to the seventh embodiment protrudes in the lateral direction at the portion of the fastening hole TH. Therefore, as illustrated in Fig. 26, the protrusions of the plurality of adjacent frame-shaped materials 20 are alternately arranged so as not to overlap each other.

In this case, after the manufacturing steps of Figs. 24A to 24G, the fastening hole TH is opened in the frame-shaped material 20 by a drill. Thereafter, the frame-shaped material 20 is cut out along a curved cut line CL using a router, a wire saw, a laser processing machine, or the like. Therefore, the frame-shaped material 20 as illustrated in Fig. 12 is singulated.

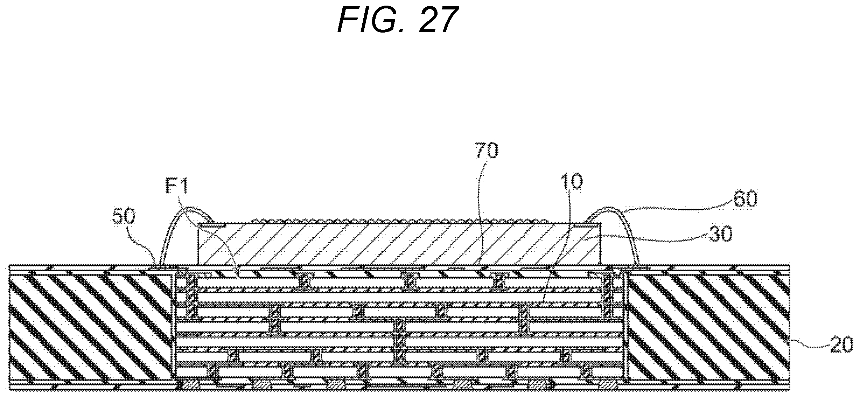

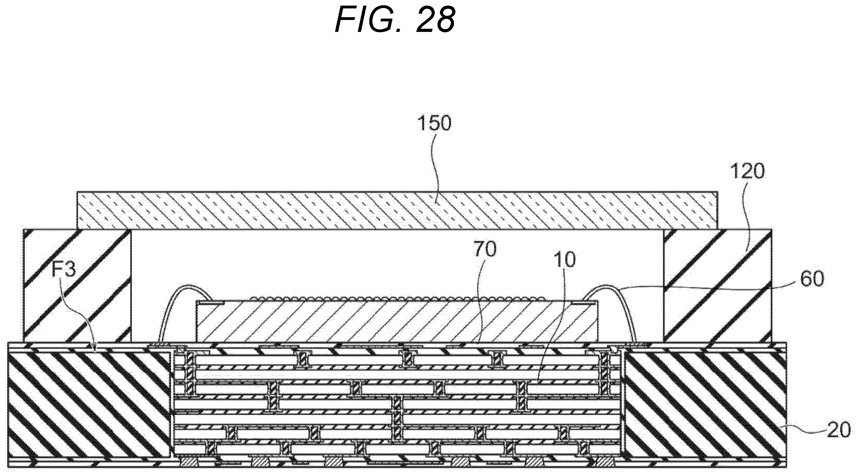

After the glass substrate 10 and the frame-shaped material 20 are singulated, as illustrated in Fig. 27, the semiconductor chip 30 is bonded onto the glass substrate 10, and the semiconductor chip 30 and the pad 50 are bonded by the metal wire 60. Next, as illustrated in Fig. 28, the frame 120 is bonded onto the third surface F3 of the frame-shaped material 20, and the sealing glass 150 is bonded onto the frame 120. Therefore, the semiconductor device according to the eighth embodiment is completed. Since the semiconductor devices according to the first to seventh embodiments can be easily estimated from the above-described manufacturing method, detailed description thereof will be omitted.

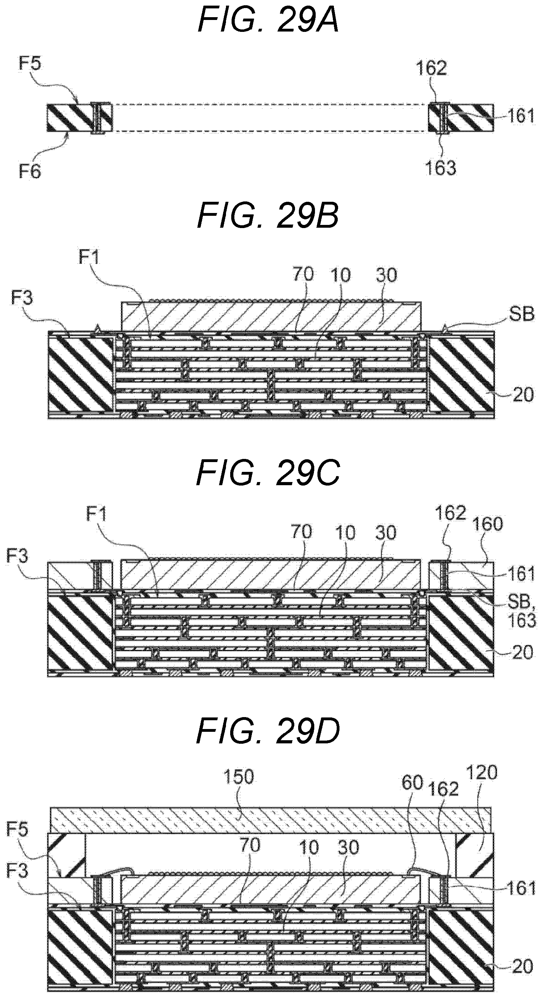

Figs. 29A to 29D are cross-sectional views illustrating examples of the manufacturing method for the semiconductor device according to the ninth embodiment. The frame-shaped material 160 illustrated in Fig. 29A is prepared. The frame-shaped material 160 has the fifth surface F5 and the sixth surface F6 opposite to the fifth surface F5. The through electrode 161 penetrating the frame-shaped material 160 is provided between the fifth surface F5 and the sixth surface F6. The pad 162 is connected to the through electrode 161 on the fifth surface F5 side. A connecting part 163 is connected to the through electrode 161 on the sixth surface F6 side. For the through electrode 161, the pad 162, and the connecting part 163, for example, a conductive material such as copper or gold is used.

After the steps illustrated in Figs. 24A to 24G, as illustrated in Fig. 29B, the semiconductor chip 30 is bonded onto the insulating film 70 on the first surface F1 of the glass substrate 10. Furthermore, a stud bump SB protruding in the Z direction is formed at a position corresponding to the connecting part 163 of the frame-shaped material 160. For the stud bump SB, a conductive material such as copper or gold is used. The stud bump SB is only required to be formed using a wire bonding device or the like.

Next, as illustrated in Fig. 29C, the frame-shaped material 160 is mounted on the third surface F3 of the frame-shaped material 20. At this time, the connecting part 163 is mounted so as to conform to the stud bump SB, and the connecting part 163 and the stud bump SB are pressure-bonded by a heating ultrasonic bonding technique. If necessary, reinforcement may be performed using an adhesive or the like. Therefore, the pad 162 is electrically connected to the wiring layer or the like of the glass substrate 10 via the through electrode 161.

After the glass substrate 10 and the frame-shaped materials 20 and 160 are singulated, as illustrated in Fig. 29D, the pads of the semiconductor chip 30 and the pads 162 of the frame-shaped material 160 are bonded by the metal wires 60. At this time, the pad 162 of the frame-shaped material 160 is closer to the height (position in the Z direction) of the pad of the semiconductor chip 30 than the third surface F3 of the frame-shaped material 20. Therefore, the length of the metal wire 60 is shortened by providing the frame-shaped material 160. Therefore, the impedance of the wiring is suppressed low, and impedance matching can be easily adapted in transmission of a high-frequency signal.

Next, the frame 120 is bonded onto the third surface F3 of the frame-shaped material 160, and the sealing glass 150 is bonded onto the frame 120. Therefore, the semiconductor device according to the ninth embodiment is completed.

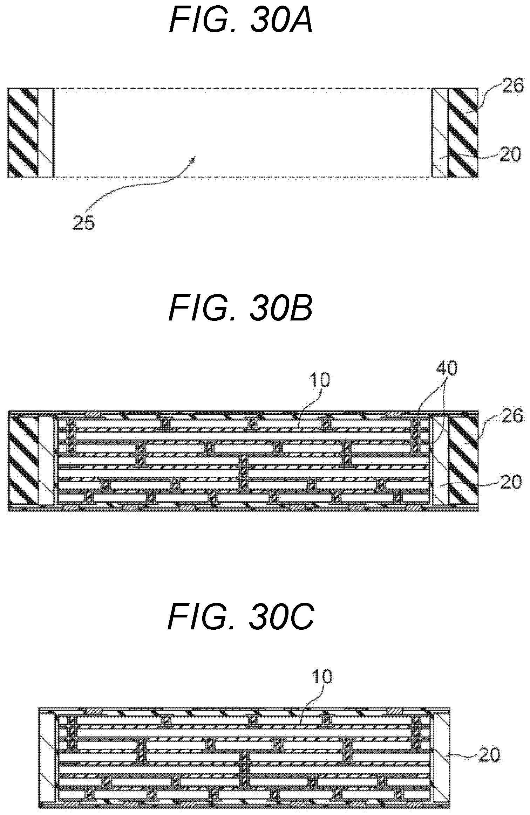

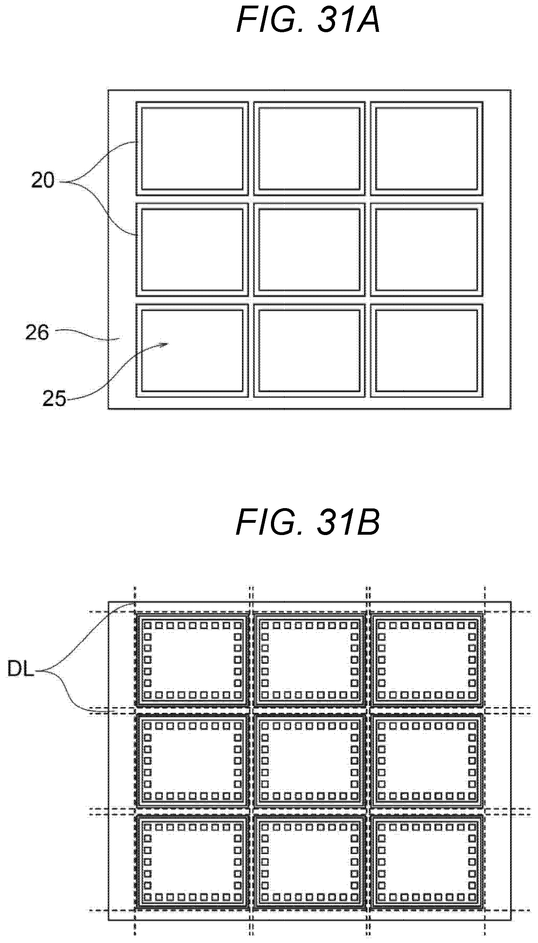

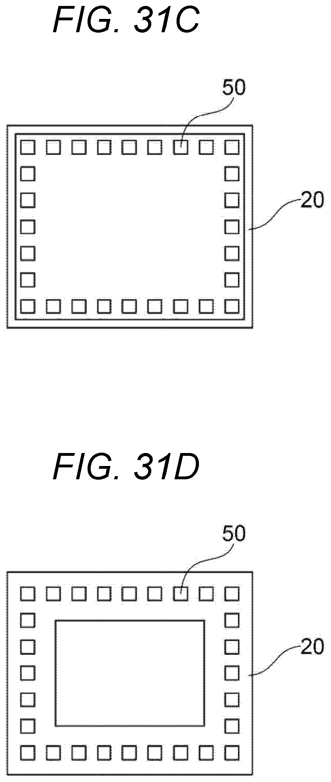

Figs. 30A, 30B, and 30C are cross-sectional views illustrating examples of the method for manufacturing the semiconductor device according to the eleventh embodiment. Figs. 31A, 31B, 31C, and 31D are plan views illustrating examples of the manufacturing method of the semiconductor device according to the eleventh embodiment.

As illustrated in Figs. 30A and 31A, a support member 26 is hollowed out in a lattice shape, and the frame-shaped material 20 is press-fitted and fitted into the inner wall surface of each space portion 25. As the frame-shaped material 20, for example, a material having higher heat dissipation than glass of the material of the glass substrate 10 is used. For example, a glass epoxy resin or a CCL material is used for the support member 26.

Next, steps illustrated in Figs. 24A to 24G are performed using the support member 26 having the frame-shaped material 20. Therefore, as illustrated in Figs. 30B and 31B, the glass substrate 10 is disposed inside the frame-shaped material 20 such that the first side surface Fs1 of the glass substrate 10 and the first inner side surface Fs2 of the frame-shaped material 20 face each other. The glass substrate 10 is fixed to the frame-shaped material 20 by the insulating film 40.

Next, the dicing line DL at the boundary between the frame-shaped material 20 and the support member 26 is cut using a laser, a router, blade dicing, or the like. Therefore, this makes it possible to singulate the semiconductor device while exposing the frame-shaped material 20. Therefore, the glass substrate 10 and the frame-shaped material 20 illustrated in Figs. 30C and 31C are formed.

Note that, as illustrated in Fig. 31C, the pad 50 may be provided above the glass substrate 10 inside the frame-shaped material 20, but in a case where the frame-shaped material 20 includes an insulating material, the pad 50 may be provided above the frame-shaped material 20 as illustrated in Fig. 31D.

### (Applications of Imaging Device to which Present Technology is Applied)

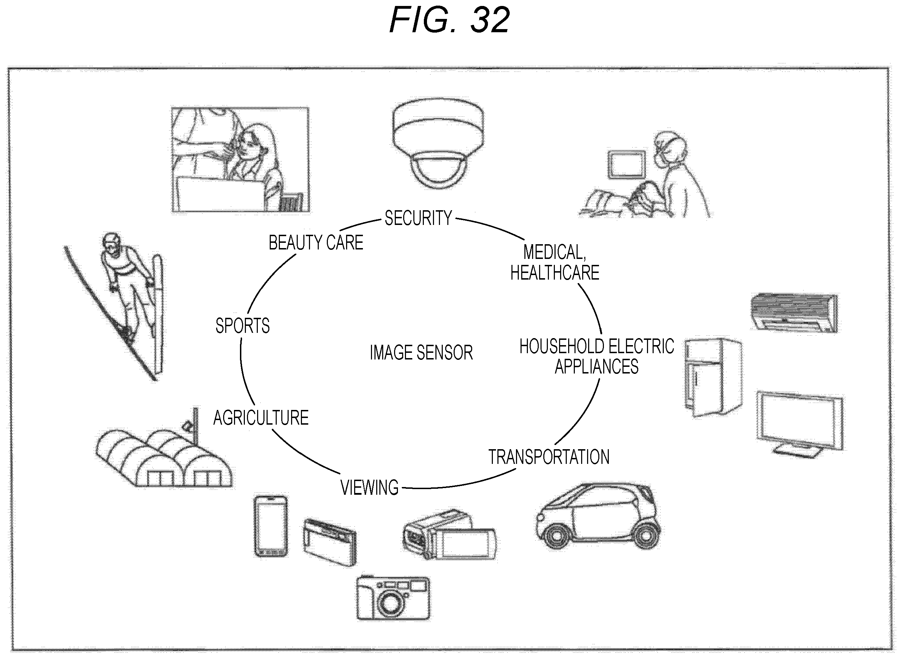

Fig. 32 is a diagram illustrating an example in which the embodiment according to the present technology is used as a CMOS image sensor.

For example, the imaging devices of the embodiments described above can be used in various cases of sensing light such as visible light, infrared light, ultraviolet light, and X-ray, as described below, for example. That is, as illustrated in Fig. 32, the above-described embodiments can also be used, for example, for devices used in the field of viewing in which images for viewing are captured, the field of transportation, the field of household electric appliances, the field of medical care and healthcare, the field of security, the field of beauty care, the field of sports, the field of agriculture, and the like.

Specifically, in the viewing field, the above-described embodiments can be used to, for example, devices for capturing an image to be viewed, such as a digital camera, a smartphone, and a mobile phone with a camera function.

In the field of transportation, for example, for safe driving such as automatic stop, recognition of a state of a driver, and the like, the above-described embodiments can be used to devices used for transportation, such as vehicle-mounted sensors that capture an image in front, rear, surroundings, interior, and the like of an automobile, monitoring cameras that monitor traveling vehicles and roads, and distance measurement sensors that measure a distance between vehicles.

In the field of household electric appliances, for example, in order to capture an image of a user's gesture and operate a device in accordance with the gesture, the above-described embodiments can be used for devices used in household electric appliances such as TV receivers, refrigerators, and air conditioners.

In the field of medical care and healthcare, for example, the above-described embodiments can be used to devices used for medical care and healthcare, such as endoscopes and devices that perform angiography by receiving infrared light.

In the security field, the above-described embodiments can be used to security devices such as a security monitoring camera and a personal authentication camera, for example.

In the field of beauty care, for example, the above-described embodiments can be used to devices used for beauty care, such as skin measuring instruments for image capturing of skin or microscopes for image capturing of scalp.

In the sports field, the above-described embodiments can be used to sports devices such as an action camera and a wearable camera for sports, for example.

In the agricultural field, the above-described embodiments can be used to agricultural devices such as a camera for monitoring a land and crop state, for example.

The present technology is applicable to other various products.

It should be noted that embodiments of the present technology are not limited to the abovementioned embodiments, and various modifications are possible without departing from the gist of the present technology.

Furthermore, the effects described in the present specification are merely examples and are not limited to any particular effects, and there may be some other effects.

Note that the present technology can also employ the following configurations.
(1) A semiconductor device including:
   a glass substrate including a first surface, a second surface opposite to the first surface, and a first side surface between the first surface and the second surface;
   a first frame-shaped material having a third surface on the first surface side, a fourth surface on the second surface side, and a first inner side surface facing the first side surface, the first frame-shaped material being provided around the glass substrate;
   a first insulating film provided between the first side surface and the first inner side surface and on the first surface and the third surface;
   a first wiring layer provided on the first insulating film of the first and third surfaces; and
   a second insulating film provided on the first wiring layer.
(2) The semiconductor device according to (1), in which
   the first insulating film is also provided on the second surface and the fourth surface, and
   the semiconductor device further includes:
      a second wiring layer provided on the first insulating film of the second and fourth surfaces; and
      a third insulating film provided on the second wiring layer.
(3) The semiconductor device according to (1) or (2), further including:
   a first pad provided on the third surface and electrically connected to the first wiring layer exposed from the second insulating film.
(4) The semiconductor device according to (2) or (3), further including:
   a second pad provided on the fourth surface and electrically connected to the second wiring layer exposed from the third insulating film.
(5) The semiconductor device according to any one of (1) to (4), in which
   the glass substrate further includes:
   a plurality of stacked glass thin plates;
   a third wiring layer provided between the glass thin plates; and
   a fourth insulating film provided between the glass thin plates.
(6) The semiconductor device according to any one of (1) to (5), in which
   the first surface of the glass substrate and the third surface of the first frame-shaped material are shifted in a thickness direction of the glass substrate, and
   a surface of the first insulating film is substantially flush above the first surface and the third surface.
(7) The semiconductor device according to any one of (1) to (6), in which
   the second surface of the glass substrate and the fourth surface of the first frame-shaped material are shifted in a thickness direction of the glass substrate, and
   a surface of the first insulating film is substantially flush above the second surface and the fourth surface.
(8) The semiconductor device according to any one of (1) to (7), in which
   the first insulating film on the second and fourth surfaces is lower in Young's modulus than the first insulating film on the first and third surfaces.
(9) The semiconductor device according to any one of (1) to (8), further including:
   an electronic component provided on the third surface or the fourth surface of the first frame-shaped material and electrically connected to the first wiring or the second wiring.
(10) The semiconductor device according to any one of (1) to (9), further including:
   a first capacitive element provided between the third surface of the first frame-shaped material and the first insulating film and configured by stacking a first conductive film, a fifth insulating film, and a second conductive film.
(11) The semiconductor device according to (10), further including:
   a second capacitive element provided between the fourth surface of the first frame-shaped material and the first insulating film and configured by stacking the first conductive film, the fifth insulating film, and the second conductive film.
(12) The semiconductor device according to any one of (1) to (11), further including:
   a first through electrode provided between the third surface and the fourth surface of the first frame-shaped material and electrically connected between the first wiring and the second wiring.
(13) The semiconductor device according to any one of (1) to (12), further including:
   a semiconductor chip provided on the glass substrate;
   a frame provided on the third surface of the first frame-shaped material;
   a lens provided on the frame and disposed above the semiconductor chip; and
   a fastening member that is fitted into a fastening hole provided in the first frame-shaped material and a fastening hole provided in the frame to fix the frame to the first frame-shaped material.
(14) The semiconductor device according to any one of (1) to (12), further including:
   a semiconductor chip provided on the glass substrate;
   a frame provided on the third surface of the first frame-shaped material; and
   a protective member provided on the frame and disposed above the semiconductor chip.
(15) The semiconductor device according to any one of (1) to (14), further including:
   a semiconductor chip provided on the glass substrate;
   a second frame-shaped material including a second through electrode electrically connected to the first wiring, the second frame-shaped material being provided on the first frame-shaped material; and
   a metal wire connecting the semiconductor chip and the second through electrode.
(16) The semiconductor device according to any one of (1) to (14), further including:
   a semiconductor chip provided on the glass substrate; and
   a frame provided on the third surface of the first frame-shaped material and having a third conductive film electrically connecting the semiconductor chip and the first wiring.
(17) A semiconductor device including:
   a glass substrate including a first surface, a second surface opposite to the first surface, and a first side surface between the first surface and the second surface;
   a first frame-shaped material having a third surface on the first surface side, a fourth surface on the second surface side, and a first inner side surface facing the first side surface, the first frame-shaped material being provided around the glass substrate and having higher heat dissipation than the glass substrate; and
   a first insulating film provided between the first side surface and the first inner side surface and on the first surface and the third surface.
(18) A manufacturing method of a semiconductor device, the method including:
   arranging a glass substrate including a first surface, a second surface opposite to the first surface, and a first side surface between the first surface and the second surface, and a first frame-shaped material including a third surface on the first surface side, a fourth surface on the second surface side, and a first inner side surface in the first frame-shaped material such that the first inner side surface and the first side surface face each other;
   forming a first insulating film between the first side surface and the first inner side surface and on the first surface and the third surface;
   forming a first wiring layer on the first insulating film of the first and third surfaces; and
   forming a second insulating film on the first wiring layer.
(19) A manufacturing method of a semiconductor device, the method including:
   arranging a glass substrate including a first surface, a second surface opposite to the first surface, and a first side surface between the first surface and the second surface, and a first frame-shaped material including a third surface on the first surface side, a fourth surface on the second surface side, and a first inner side surface, and having higher heat dissipation than the glass substrate in the first frame-shaped material such that the first inner side surface and the first side surface face each other; and
   forming a first insulating film between the first side surface and the first inner side surface and on the first surface and the third surface.

Note that the present disclosure is not limited to the above-described embodiments, and various modifications can be made without departing from the gist of the present disclosure. Furthermore, the effects described in the present description are merely examples and are not limited, and other effects may be provided.

### REFERENCE SIGNS LIST

- 10: Glass substrate
- 11: Glass thin plate
- 12: Wiring layer
- 13: Insulating film
- 14: Through electrode
- 20: Frame-shaped material
- 40: Insulating film
- 40 to 42: Redistribution layer
- 30: Semiconductor chip
- 50: Pad
- 60: Metal wire
- 70: Insulating film

## Claims

1. A semiconductor device comprising:
a glass substrate including a first surface, a second surface opposite to the first surface, and a first side surface between the first surface and the second surface;
a first frame-shaped material having a third surface on the first surface side, a fourth surface on the second surface side, and a first inner side surface facing the first side surface, the first frame-shaped material being provided around the glass substrate;
a first insulating film provided between the first side surface and the first inner side surface and on the first surface and the third surface;
a first wiring layer provided on the first insulating film of the first and third surfaces; and
a second insulating film provided on the first wiring layer.

2. The semiconductor device according to claim 1, wherein
the first insulating film is also provided on the second surface and the fourth surface, and
the semiconductor device further comprises:
a second wiring layer provided on the first insulating film of the second and fourth surfaces; and
a third insulating film provided on the second wiring layer.

3. The semiconductor device according to claim 1, further comprising:
a first pad provided on the third surface and electrically connected to the first wiring layer exposed from the second insulating film.

4. The semiconductor device according to claim 2, further comprising:
a second pad provided on the fourth surface and electrically connected to the second wiring layer exposed from the third insulating film.

5. The semiconductor device according to claim 1, wherein
the glass substrate further includes:
a plurality of stacked glass thin plates;
a third wiring layer provided between the glass thin plates; and
a fourth insulating film provided between the glass thin plates.

6. The semiconductor device according to claim 1, wherein
the first surface of the glass substrate and the third surface of the first frame-shaped material are shifted in a thickness direction of the glass substrate, and
a surface of the first insulating film is substantially flush above the first surface and the third surface.

7. The semiconductor device according to claim 1, wherein
the second surface of the glass substrate and the fourth surface of the first frame-shaped material are shifted in a thickness direction of the glass substrate, and
a surface of the first insulating film is substantially flush above the second surface and the fourth surface.

8. The semiconductor device according to claim 1, wherein
the first insulating film on the second and fourth surfaces is lower in Young's modulus than the first insulating film on the first and third surfaces.

9. The semiconductor device according to claim 1, further comprising:
an electronic component provided on the third surface or the fourth surface of the first frame-shaped material and electrically connected to the first wiring layer or the second wiring layer.

10. The semiconductor device according to claim 1, further comprising:
a first capacitive element provided between the third surface of the first frame-shaped material and the first insulating film and configured by stacking a first conductive film, a fifth insulating film, and a second conductive film.

11. The semiconductor device according to claim 10, further comprising:
a second capacitive element provided between the fourth surface of the first frame-shaped material and the first insulating film and configured by stacking the first conductive film, the fifth insulating film, and the second conductive film.

12. The semiconductor device according to claim 1, further comprising:
a first through electrode provided between the third surface and the fourth surface of the first frame-shaped material and electrically connected between the first wiring layer and the second wiring layer.

13. The semiconductor device according to claim 1, further comprising:
a semiconductor chip provided on the glass substrate;
a frame provided on the third surface of the first frame-shaped material;
a lens provided on the frame and disposed above the semiconductor chip; and
a fastening member that is fitted into a fastening hole provided in the first frame-shaped material and a fastening hole provided in the frame to fix the frame to the first frame-shaped material.

14. The semiconductor device according to claim 1, further comprising:
a semiconductor chip provided on the glass substrate;
a frame provided on the third surface of the first frame-shaped material; and
a protective member provided on the frame and disposed above the semiconductor chip.

15. The semiconductor device according to claim 1, further comprising:
a semiconductor chip provided on the glass substrate;
a second frame-shaped material including a second through electrode electrically connected to the first wiring layer, the second frame-shaped material being provided on the first frame-shaped material; and
a metal wire connecting the semiconductor chip and the second through electrode.

16. The semiconductor device according to claim 1, further comprising:
a semiconductor chip provided on the glass substrate; and
a frame provided on the third surface of the first frame-shaped material and having a third conductive film electrically connecting the semiconductor chip and the first wiring layer.

17. A semiconductor device comprising:
a glass substrate including a first surface, a second surface opposite to the first surface, and a first side surface between the first surface and the second surface;
a first frame-shaped material having a third surface on the first surface side, a fourth surface on the second surface side, and a first inner side surface facing the first side surface, the first frame-shaped material being provided around the glass substrate and having higher heat dissipation than the glass substrate; and
a first insulating film provided between the first side surface and the first inner side surface and on the first surface and the third surface.

18. A manufacturing method of a semiconductor device, the method comprising:
arranging a glass substrate including a first surface, a second surface opposite to the first surface, and a first side surface between the first surface and the second surface, and a first frame-shaped material including a third surface on the first surface side, a fourth surface on the second surface side, and a first inner side surface in the first frame-shaped material such that the first inner side surface and the first side surface face each other;
forming a first insulating film between the first side surface and the first inner side surface and on the first surface and the third surface;
forming a first wiring layer on the first insulating film of the first and third surfaces; and
forming a second insulating film on the first wiring layer.

19. A manufacturing method of a semiconductor device, the method comprising:
arranging a glass substrate including a first surface, a second surface opposite to the first surface, and a first side surface between the first surface and the second surface, and a first frame-shaped material including a third surface on the first surface side, a fourth surface on the second surface side, and a first inner side surface, and having higher heat dissipation than the glass substrate in the first frame-shaped material such that the first inner side surface and the first side surface face each other; and
forming a first insulating film between the first side surface and the first inner side surface and on the first surface and the third surface.
